(19) Europäisches Patentamt
European Patent Office
Office européen des brevets

(11) EP 1 550 174 B1

(12) # EUROPÄISCHE PATENTSCHRIFT

(45) Veröffentlichungstag und Bekanntmachung des Hinweises auf die Patenterteilung:
**11.05.2011 Patentblatt 2011/19**

(21) Anmeldenummer: **03747913.6**

(22) Anmeldetag: **20.08.2003**

(51) Int Cl.:
***H01M 8/10*** *(2006.01)*

(86) Internationale Anmeldenummer:
**PCT/EP2003/009198**

(87) Internationale Veröffentlichungsnummer:
**WO 2004/030135 (08.04.2004 Gazette 2004/15)**

(54) **PROTONENLEITENDE MEMBRAN UND DEREN VERWENDUNG**

PROTON-CONDUCTING MEMBRANE AND USE THEREOF

MEMBRANE CONDUCTRICE DE PROTONS ET SON UTILISATION

(84) Benannte Vertragsstaaten:
**AT BE BG CH CY CZ DE DK EE ES FI FR GB GR HU IE IT LI LU MC NL PT RO SE SI SK TR**

(30) Priorität: **13.09.2002 DE 10242708**

(43) Veröffentlichungstag der Anmeldung:
**06.07.2005 Patentblatt 2005/27**

(73) Patentinhaber: **BASF Fuel Cell Research GmbH**
**67056 Ludwigshafen (DE)**

(72) Erfinder:
- **CALUNDANN, Gordon**
  **North Plainfield, NJ 07060 (US)**
- **BENICEWICZ, Brian**
  **Loudonville, NY 12211 (US)**
- **BAURMEISTER, Jochen**
  **65817 Eppstein (DE)**

(74) Vertreter: **Luderschmidt, Schüler & Partner**
**Patentanwälte**
**John-F.-Kennedy-Strasse 4**
**65189 Wiesbaden (DE)**

(56) Entgegenhaltungen:

| | |
|---|---|
| **EP-A- 0 476 560** | **WO-A-02/36249** |
| **WO-A-02/38650** | **WO-A-02/071518** |
| **WO-A-02/081547** | **WO-A-02/088219** |
| **WO-A-02/102881** | **WO-A-03/007411** |
| **WO-A-03/022412** | **US-A- 3 313 783** |
| **US-A- 5 098 985** | **US-A- 5 218 076** |
| **US-A- 5 312 895** | **US-A- 5 492 996** |
| **US-A- 5 633 337** | **US-A- 5 674 969** |

EP 1 550 174 B1

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

**Beschreibung**

Verfahren zur Herstellung einer Protonenleitenden Membran und deren Verwendung

Die vorliegende Erfindung betrifft ein Verfahren zur Herstellung einer protonenleitenden Polymermembran auf Basis von Polyazolen, die aufgrund ihrer hervorragenden chemischen und thermischen Eigenschaften vielfältig eingesetzt werden kann und sich insbesondere als Polymer-Elektrolyt-Membran (PEM) in sogenannten PEM-Brennstoffzellen eignet.

Polyazole wie beispielsweise Polybenzimidazole (®Celazole) sind seit langem bekannt. Die Herstellung derartiger Polybenzimidazole (PBI) erfolgt üblicherweise durch Umsetzung von 3,3',4,4'-Tetraaminobiphenyl mit Isophthalsäure oder Diphenyl-isophthalsäure bzw. deren Estern in der Schmelze. Das enstehende Präpolymer erstarrt im Reaktor und wird anschließend mechanisch zerkleinert. Anschließend wird das pulverförmige Präpolymer in einer Festphasen-Polymerisation bei Temperaturen von bis zu 400°C endpolymerisiert und das gewünschte Polybenzimidazole erhalten.

Aus US-A-5633337 ist ein Verfahren zur Herstellung von Polybenzimidazolen bekannt, bei welchem die zugrunde liegenden Monomere in Polyphosphorsäure (PPA) polymerisiert und anschließend das erhaltene Polymer in Wasser gefällt wird. Das erhaltene Polybenzimidazol wird anschließend abgetrennt und getrocknet.

Zur Herstellung von Polymerfolien wird das PBI in einem weiteren Schritt in polaren, , aprotischen Lösemitteln wie beispielsweise Dimethylacetamid (DMAc) gelöst und eine Folie mittels klassischer Verfahren erzeugt.

Protonenleitende, d.h. mit Säure dotierte Polyazol-Membranen für den Einsatz in PEM-Brennstoffzellen sind bereits bekannt. Die basischen Polyazol-Folien werden mit konzentrierter Phosphorsäure oder Schwefelsäure dotiert und wirken dann als Protonen leiter und Separatoren in sogenannten Polymerelektrolyt-Membran-Brennstoffzellen (PEM-Brennstoffzellen).

Bedingt durch die hervorragenden Eigenschaften des Polyazol-Polymeren können derartige Polymerelektrolytmembranen - zu Membran-Elektroden-Einheiten (MEE) verarbeitet - bei Dauerbetriebstemperaturen oberhalb 100°C insbesondere oberhalb 120°C in Brennstoffzellen eingesetzt werden. Diese hohe Dauerbetriebstemperatur erlaubt es die Aktivität der in der Membran-Elektroden-Einheit (MEE) enthaltenen Katalysatoren auf Edelmetallbasis zu erhöhen. Insbesondere bei der Verwendung von sogenannten Reformaten aus Kohlenwasserstoffen sind im Reformergas deutliche Mengen an Kohlenmonoxid enthalten, die überlicherweise durch eine aufwendige Gasaufbereitung bzw. Gasreinigung entfernt werden müssen. Durch die Möglichkeit die Betriebstemperatur zu erhöhen, können deutlich höhere Konzentrationen an CO-Verunreinigungen dauerhaft toleriert werden.

Durch Einsatz von Polymer-Elektrolyt-Membranen auf Basis von Polyazol-Polymeren kann zum einen auf die aufwendige Gasaufbereitung bzw. Gasreinigung teilweise verzichtet werden und andererseits die Katalysatorbeladung in der Membran-Elektroden-Einheit reduziert werden. Beides ist für einen Masseneinsatz von PEM-Brennstoffzellen unabdingbare Voraussetzung, da ansonsten die Kosten für ein PEM-Brennstoffzellen-System zu hoch sind.

Die bislang bekannten mit Säure dotierten Polymermembrane auf Basis von Polyazolen zeigen bereits ein günstiges Eigenschaftsprofil. Aufgrund der für PEM-Brennstoffzellen angestrebten Anwendungen, insbesondere im Automobilbereich- und der dezentralen Strom- und Wärmeerzeugung (Stationärbereich), sind diese insgesamt jedoch noch zu verbessern. Darüber hinaus haben die bislang bekannten Polymermembranen einen hohen Gehalt an Dimethylacetamid (DMAc), der mittels bekannter Trocknungsmethoden nicht vollständig entfernt werden kann. In der deutschen Patentanmeldung Nr. 10109829.4 wird eine Polymermembran auf Basis von Polyazolen beschrieben, bei der die DMAc-Kontamination beseitigt wurde. Derartige Polymermembran zeigen zwar verbesserte mechanische Eigenschaften, hinsichtlich der spezifischen Leitfähigkeit werden jedoch 0,1 S/cm (bei 140°C) nicht überschritten.

Aufgabe der vorliegenden Erfindung ist es ein verfahren zur Herstellung von Säure enthaltende Polymermembranen auf Basis von Polyazolen bereitzustellen, die einerseits die anwendungstechnischen Vorteile der Polymermembran auf Basis von Polyazolen aufweisen und andererseits eine gesteigerte spezifische Leitfähigkeit, insbesondere bei Betriebstemperaturen oberhalb von 100°C, aufweisen und zusätzliche ohne Brenngasbefeuchtung auskommen.

Wir haben nun gefunden, daß eine protonenleitende Membran auf Basis von Polyazolen erhalten werden kann, wenn die zugrundeliegenden Monomeren in Phosphorsäure suspendiert bzw. gelöst, in eine dünne Form gerakelt und in der Phosphorsäure polymerisiert werden.

Bei dieser neuen Membran kann auf die in der deutschen Patentanmeldung Nr. 10109829.4 beschriebene spezielle Nachbehandlung, eine zusätzliche Polymerlösungherstellung sowie die nachträgliche Dotierung der Folie verzichtet werden. Die dotierten Polymermembranen zeigen eine signifikant verbesserte Protonenleitfähigkeit.

Gegenstand der vorliegenden Erfindung ist ein

Verfahren zur Herstellung einer protonenleitenden Polymermembran auf Basis von Polyazolen umfassend die Schritte

A) Mischen von einem oder mehreren aromatischen Tetra-Amino-Verbindungen mit einer oder mehreren aromatischen Carbonsäuren bzw. deren Estern, die mindestens zwei Säuregruppen pro Carbonsäure-Monomer enthalten, oder Mischen von einer oder mehreren aromatischen und/oder heteroaromatischen Diaminocarbonsäuren, in Phosphorsäure mit einer Konzentration von 85% und mehr, die keine Polyphosphorsäure der Formel $H_{n+2}P_nO_{3n+1}$ (n≥ 2) aufweist, unter Ausbildung einer Lösung und/oder Dispersion,
B) Erwärmen der gemäß Schritt A) erhaltenen Lösung und/oder Dispersion auf Temperaturen von bis zu 350°C, vorzugsweise bis zu 280°C unter Ausbildung des Polyazol-Polymeren,
C) Aufbringen einer Schicht unter Verwendung der Mischung gemäß Schritt B) auf einem Träger,
D) Behandlung der in Schritt C) gebildeten Membran.

Bei den erfindungsgemäß eingesetzten aromatischen und heteroaromatischen Tetra-Amino-Verbindungen handelt es sich vorzugsweise um 3,3',4,4'-Tetraaminobiphenyl, 2,3,5,6-Tetraaminopyridin, 1,2,4,5-Tetraaminobenzol, 3,3',4,4'-Tetraaminodiphenylsulfon, 3,3',4,4'-Tetraaminodiphenylether, 3,3',4,4'-Tetraaminobenzophenon, 3,3',4,4'-Tetraaminodiphenylmethan und 3,3',4,4'-Tetraaminodiphenyldimethylmethan sowie deren Salze, insbesondere deren Mono-, Di-, Tri- und Tetrahydrochloridderivate.

Bei den erfindungsgemäß eingesetzten aromatischen Carbonsäuren handelt es sich um Di-carbonsäuren und Tri-carbonsäuren und Tetra-Carbonsäuren bzw. deren Estern oder deren Anhydride oder deren Säurechloride. Der Begriff aromatische Carbonsäuren umfasst gleichermaßen auch heteroaromatische Carbonsäuren. Vorzugsweise handelt es sich bei den aromatischen Dicarbonsäuren um Isophthalsäure, Terephthalsäure, Phthalsäure, 5-Hydroxyisophthalsäure, 4-Hydroxyisophthalsäure, 2-Hydroxyterephthalsäure, 5-Aminoisophthalsäure, 5-N,N-Dimethylaminoisophthalsäure, 5-N,N-Diethylaminoisophthalsäure, 2,5-Dihydroxyterephthalsäure, 2,6-Dihydroxyisophthalsäure, 4,6-Dihydroxyisophthalsäure, 2,3-Dihydroxyphthalsäure, 2,4-Dihydroxyphthalsäure. 3,4-Dihydroxyphthalsäure, 3-Fluorophthalsäure, 5-Fluoroisophthalsäure, 2-Fluoroterphthalsäure, Tetrafluorophthalsäure, Tetrafluoroisophthalsäure, Tetrafluoroterephthalsäure,1,4-Naphthalindicarbonsäure, 1,5-Naphthalindicarbonsäure, 2,6-Naphthalindicarbonsäure, 2,7-Naphthalindicarbonsäure, Diphensäure, 1,8-dihydroxynaphthalin-3,6-dicarbonsäure, Diphenylether-4,4'-dicarbonsäure, Benzophenon-4,4'-dicarbonsäure, Diphenylsulfon-4,4'-dicarbonsäure, Biphenyl-4,4'-dicarbonsäure, 4-Trifluoromethylphthalsäure, 2,2-Bis(4-carboxyphenyl)hexafluoropropan, 4,4'-Stilbendicarbonsäure, 4-Carboxyzimtsäure, bzw. deren C1-C20-Alkyl-Ester oder C5-C12-Aryl-Ester, oder deren Säureanhydride oder deren Säurechloride. Bei den aromatischen Tri-, tetra-carbonsäuren bzw. deren C1-C20-Alkyl-Ester oder C5-C12-Aryl-Ester oder deren Säureanhydride oder deren Säurechloride handelt es sich bevorzugt um 1,3,5-Benzol-tricarbonsäure (Trimesic acid), 1,2,4-Benzol-tricarbonsäure (Trimellitic acid), (2-Carboxyphenyl)iminodiessigsäure, 3,5,3'-Biphenyltricarbonsäure, 3,5,4'-Biphenyltricarbonsäure.
Bei den aromatischen Tetracarbonsäuren bzw. deren C1-C20-Alkyl-Ester oder C5-C12-Aryl-Ester oder deren Säureanhydride oder deren Säurechloride handelt es sich bevorzugt um 3,5,3',5'-biphenyltetracarboxylic acid, 1,2,4,5-Benzoltetracarbonsäure, Benzophenontetracarbonsäure, 3,3',4,4'-Biphenyltetracarbonsäure, 2,2',3,3'-Biphenyltetracarbonsäure, 1,2,5,6-Naphthalintetracarbonsäure, 1,4,5,8-Naphthalintetracarbonsäure.
Bei den erfindungsgemäß eingesetzten heteroaromatischen Carbonsäuren handelt es sich um heteroaromatischen Dicarbonsäuren und Tri-carbonsäuren und Tetra-Carbonsäuren bzw. deren Estern oder deren Anhydride. Als Heteroaromatische Carbonsäuren werden aromatische Systeme verstanden welche mindestens ein Stickstoff, Sauerstoff, Schwefel oder Phosphoratom im Aromaten enthalten. Vorzugsweise handelt es sich um Pyridin-2,5-dicarbonsäure, Pyridin-3,5-dicarbonsäure, Pyridin-2,6-dicarbonsäure, Pyridin-2,4-dicarbonsäure, 4-Phenyl-2,5-pyridindicarbonsäure, 3,5-Pyrazoldicarbonsäure, 2,6 -Pyrimidindicarbonsäure, 2,5-Pyrazindicarbonsäure, 2,4,6-Pyridintricarbonsäure, Benzimidazol-5,6-dicarbonsäure, sowie deren C1-C20-Alkyl-Ester, C5-C12-Aryl-Ester, deren Säureanhydride oder deren Säurechloride.

Der Gehalt an Tri-carbonsäure bzw. Tetracarbonsäuren (bezogen auf eingesetzte Dicarbonsäure) beträgt zwischen 0 und 30 Mol-%, vorzugsweise 0,5 und 20 Mol %, insbesondere 1 und 20 Mol-%.

Bei den erfindungsgemäß eingesetzten aromatischen und heteroaromatischen Diaminocarbonsäuren handelt es sich bevorzugt um Diaminobenzoesäure und deren Mono und Dihydrochloridderivate.

Bevorzugt werden in Schritt A) Mischungen von mindestens 2 verschiedenen aromatischen Carbonsäuren einzusetzen. Besonders bevorzugt werden Mischungen eingesetzt, die neben aromatischen Carbonsäuren auch heteroaromatische Carbonsäuren enthalten. Das Mischungsverhältnis von aromatischen Carbonsäuren zu heteroaromatischen Carbonsäuren beträgt zwischen 1:99 und 99:1, vorzugsweise 1:50 bis 50:1.
Bei diesem Mischungen handelt es sich insbesondere um Mischungen von N-heteroaromatischen Di-carbonsäuren und aromatischen Dicarbonsäuren. Nicht limitierende Beispiele dafür sind Isophthalsäure, Terephthalsäure, Phthalsäure, 2,5-Dihydroxyterephthalsäure, 2,6-Dihydroxyisophthalsäure, 4,6-Dihydroxyisophthalsäure, 2,3-Dihydroxyphthalsäure, 2,4-Dihydroxyphthalsäure. 3,4-Dihydroxyphthalsäure,1,4-Naphthalindicarbonsäure, 1,5-Naphthalindicarbonsäure, 2,6-Naphthalindicarbonsäure, 2,7-Naphthalindicarbonsäure, Diphensäure, 1,8-dihydroxynaphthalin-3,6-dicarbonsäure, Diphenylether-4,4'-dicarbonsäure, Benzophenon-4,4'-dicarbonsäure, Diphenylsulfon-4,4'-dicarbonsäure, Biphenyl-4,4'-dicarbonsäure, 4-Trifluoromethylphthalsäure, Pyridin-2,5-dicarbonsäure, Pyridin-3,5-dicarbonsäure, Pyridin-2,6-dicarbonsäure, Pyridin-2,4-dicarbonsäure, 4-Phenyl-2,5-pyridindicarbonsäure, 3,5-Pyrazoldicarbonsäure, 2,6 -Pyrimidindicarbonsäure,2,5-Pyrazindicarbonsäure.

Bei der in Schritt A) verwendeten Phosphorsäure handelt es sich um handelsübliche Phosphorsäuren, wie

diese beispielsweise von Riedel-de Haen erhältlich sind, wobei diese jedoch keine Polyphosphorsäuren $H_{n+2}P_nO_{3n+1}$ ($n \geq 2$) enthaltend. Hierbei handelt es sich um konzentrierte Phosphorsäuren $H_3PO_4$ die üblicherweise 85-%ig ist, wobei auch hoher konzentrierte Phosphorsäuren möglich, sind.

Die in Schritt A) erzeugte Mischung weist ein Gewichtsverhältnis Phosphorsäure zu Summe aller Monomeren von 1:10000 bis 10000:1, vorzugsweise 1:1000 bis 1000:1, insbesondere 1:100 bis 100:1, auf.

Die Polymerisation der Mischung aus Schritt A) erfolgt in Schritt B). Hierzu wird die Mischung auf eine Temperatur von bis zu 350°C, vorzugsweise von bis zu 280°C, insbesondere von bis zu 250°C erhitzt. Die Mischung wird vorzugsweise in einem geschlossenen Reaktor erhitzt, so daß sich die Phosphorsäure nicht oberhalb von 200°C durch Wasserabspaltung in Diphosphorsäure ($H_4P_2O_7$), d.h. die einfachste Form der Polyphosphorsäuren $H_{n+2}P_nO_{3n+1}$ (n = 2), überführt wird. Die Polymerisation findet somit unter dem bei der jeweiligen Temperatur vorhandenen Wasserdampf-Partialdruck statt. In einer Variante kann das durch die Polykondensation gebildete Wasser ganz oder teilweise entfernt werden. Dies kann durch Abtrennung des Wassers oder durch Verwendung von Anhydriden bewirkt werden.

Das in Schritt B) gebildete Polymere auf Basis von Polyazol enthält wiederkehrende Azoleinheiten der allgemeinen Formel (I) und/oder (II) und/oder (III) und/oder (IV) und/oder (V) und/oder (VI) und/oder (VII) und/oder (VIII) und/oder (IX) und/oder (X) und/oder (XI) und/oder (XII) und/oder (XIII) und/oder (XIV) und/oder (XV) und/oder (XVI) und/oder (XVI) und/oder (XVII) und/oder (XVIII) und/oder (XIX) und/oder (XX) und/oder (XXI) und/oder (XXII)

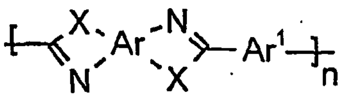

(I)

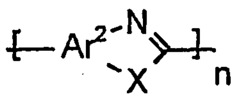

(II)

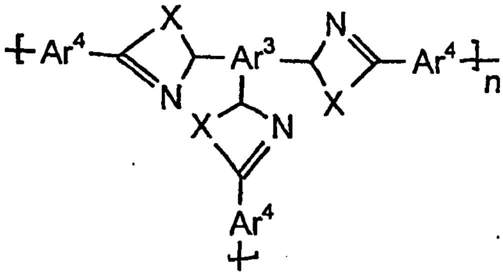

(III)

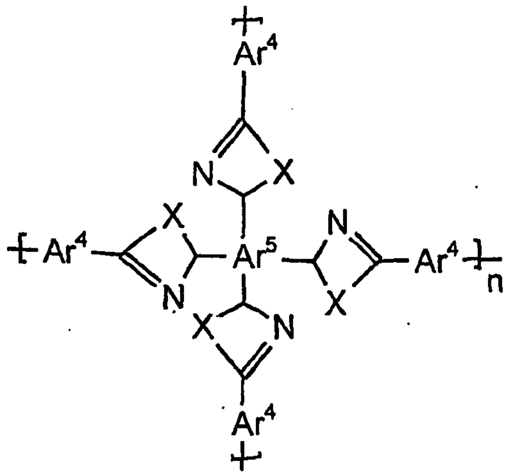

(IV)

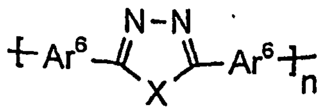

(V)

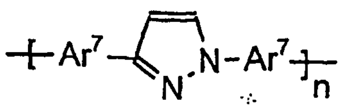

(VI)

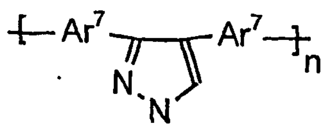

(VII)

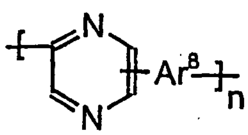

(VIII)

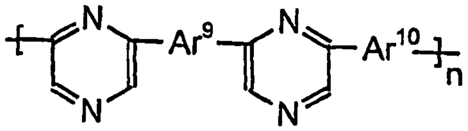

(IX)

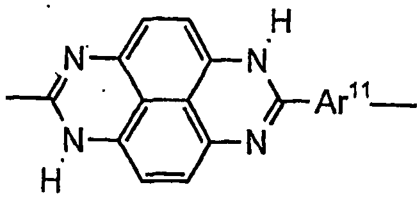

(X)

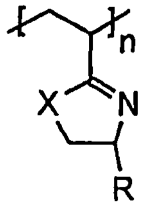

(XI)

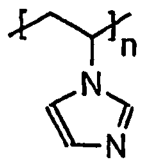

(XII)

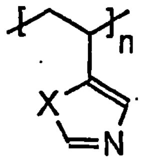

(XIII)

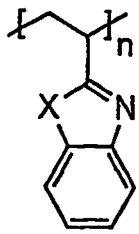

(XIV)

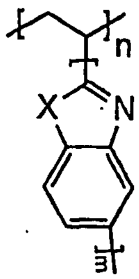

(XV)

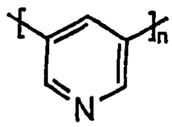

(XVI)

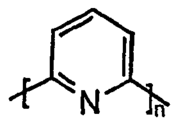

(XVII)

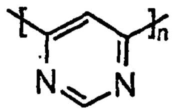

(XVIII)

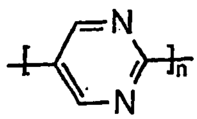

(XIX)

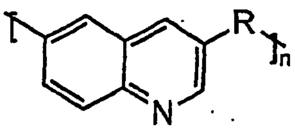

(XX)

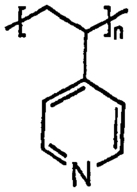

(XXI)

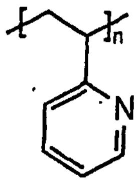

(XXII)

worin

- Ar gleich oder verschieden sind und für eine vierbindige aromatische oder heteroaromatische Gruppe, die ein- oder mehrkernig sein kann,
- $Ar^1$ gleich oder verschieden sind und für eine zweibindige aromatische oder heteroaromatische Gruppe, die ein- oder mehrkernig sein kann,
- $Ar^2$ gleich oder verschieden sind und für eine zwei oder dreibindige aromatische oder heteroaromatische Gruppe, die ein-oder mehrkernig sein kann,
- $Ar^3$ gleich oder verschieden sind und für eine dreibindige aromatische oder heteroaromatische Gruppe, die ein- oder mehrkernig sein kann,
- $Ar^4$ gleich oder verschieden sind und für eine dreibindige aromatische oder heteroaromatische Gruppe, die ein- oder mehrkernig sein kann,
- $Ar^5$ gleich oder verschieden sind und für eine vierbindige aromatische oder heteroaromatische Gruppe, die ein- oder mehrkernig sein kann,
- $Ar^6$ gleich oder verschieden sind und für eine zweibindige aromatische oder heteroaromatische Gruppe, die ein- oder mehrkernig sein kann,
- $Ar^7$ gleich oder verschieden sind und für eine zweibindige aromatische oder heteroaromatische Gruppe, die ein- oder mehrkernig sein kann,
- $Ar^8$ gleich oder verschieden sind und für eine dreibindige aromatische oder heteroaromatische Gruppe, die ein- oder mehrkernig sein kann,
- $Ar^9$ gleich oder verschieden sind und für eine zwei- oder drei- oder vierbindige aromatische oder heteroaromatische Gruppe, die ein- oder mehrkernig sein kann,
- $Ar^{10}$ gleich oder verschieden sind und für eine zwei- oder dreibindige aromatische oder heteroaromatische Gruppe, die ein- oder mehrkernig sein kann,
- $Ar^{11}$ gleich oder verschieden sind und für eine zweibindige aromatische oder heteroaromatische Gruppe, die ein- oder mehrkernig sein kann,
- X gleich oder verschieden ist und für Sauerstoff, Schwefel oder eine Aminogruppe, die ein Wasserstoffatom, eine 1- 20 Kohlenstoffatome aufweisende Gruppe, vorzugsweise eine verzweigte oder nicht verzweigte Alkyl-oder Alkoxygruppe, oder eine Arylgruppe als weiteren Rest trägt
- R gleich oder verschieden für Wasserstoff, eine Alkylgruppe und eine aromatische Gruppe steht und
- n, m eine ganze Zahl größer gleich 10, bevorzugt größer gleich 100 ist.

Bevorzugte aromatische oder heteroaromatische Gruppen leiten sich von Benzol, Naphthalin, Biphenyl, Diphenylether, Diphenylmethan, Diphenyldimethylmethan, Bisphenon, Diphenylsulfon, Chinolin, Pyridin, Bipyridin, Pyridazin, Pyrimidin, Pyrazin, Triazin, Tetrazin, Pyrol, Pyrazol, Anthracen, Benzopyrrol, Benzotriazol, Benzooxathiadiazol, Benzooxadiazol, Benzopyridin, Benzopyrazin, Benzopyrazidin, Benzopyrimidin, Benzopyrazin, Benzotriazin, Indolizin, Chinolizin, Pyridopyridin, Imidazopyrimidin, Pyrazinopyrimidin, Carbazol, Aciridin, Phenazin, Benzochinolin, Phenoxazin, Phenothiazin, Acridizin, Benzopteridin, Phenanthrolin und Phenanthren, die gegebenenfalls auch substituiert sein können, ab.

Dabei ist das Substitionsmuster von $Ar^1$, $Ar^4$, $Ar^6$,$Ar^7$, $Ar^8$, $Ar^9$, $Ar^{10}$, $Ar^{11}$ beliebig, im Falle vom Phenylen beispielsweise kann $Ar^1$, $Ar^4$, $Ar^6$, $Ar^7$, $Ar^8$, $Ar^9$, $Ar^{10}$, $Ar^{11}$ ortho-, meta- und para-Phenylen sein. Besonders bevorzugte Gruppen leiten sich von Benzol und Biphenylen, die gegebenenfalls auch substituiert sein können, ab.

Bevorzugte Alkylgruppen sind kurzkettige Alkylgruppen mit 1 bis 4 Kohlenstoffatomen, wie z. B. Methyl-, Ethyl-, n- oder i-Propyl- und t-Butyl-Gruppen.

Bevorzugte aromatische Gruppen sind Phenyl- oder Naphthyl-Gruppen. Die Alkylgruppen und die aromatischen Gruppen können substituiert sein.

Bevorzugte Substituenten sind Halogenatome wie z. B. Fluor, Aminogruppen, Hydroxygruppen oder kurzkettige Alkylgruppen wie z. B. Methyl- oder Ethylgruppen.

Bevorzugt sind Polyazole mit wiederkehrenden Einheiten der Formel (I) bei denen die Reste X innerhalb einer wiederkehrenden Einheit gleich sind.

Die Polyazole können grundsätzlich auch unterschiedliche wiederkehrende Einheiten aufweisen, die sich beispielsweise in ihrem Rest X unterscheiden. Vorzugsweise jedoch weist es nur gleiche Reste X in einer wiederkehrenden Einheit auf.

Weitere bevorzugte Polyazol-Polymere sind Polyimidazole, Polybenzthiazole, Polybenzoxazole, Polyoxadiazole, Polyquinoxalines, Polythiadiazole Poly(pyridine), Poly(pyrimidine), und Poly(tetrazapyrene).

In einer weiteren Ausführungsform der vorliegenden Erfindung ist das Polymer enthaltend wiederkehrende Azoleinheiten ein Copolymer oder ein Blend, das mindestens zwei Einheiten der Formel (I) bis (XXII) enthält, die sich voneinander unterscheiden. Die Polymere können als Blockcopolymere (Diblock, Triblock), statistische Copolymere, periodische Copolymere und/oder alternierende Polymere vorliegen.

In einer besonders bevorzugten Ausführungsform der vorliegenden Erfindung ist das Polymer enthaltend wiederkehrende Azoleinheiten ein Polyazol, das nur Einheiten der Formel (I) und/oder (II) enthält.

Die Anzahl der wiederkehrende Azoleinheiten im Polymer ist vorzugsweise eine ganze Zahl größer gleich 10. Besonders bevorzugte Polymere enthalten mindestens 100 wiederkehrende Azoleinheiten.

Im Rahmen der vorliegenden Erfindung sind Polymere enthaltend wiederkehrenden Benzimidazoleinheiten bevorzugt. Einige Beispiele der äußerst zweckmäßigen Polymere enthaltend wiederkehrende Benzimidazoleinheiten werden durch die nachfolgende Formeln wiedergegeben:

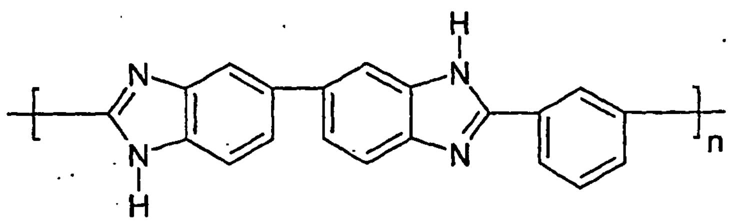

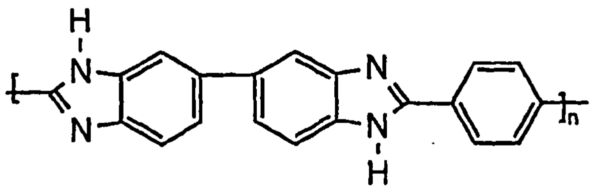

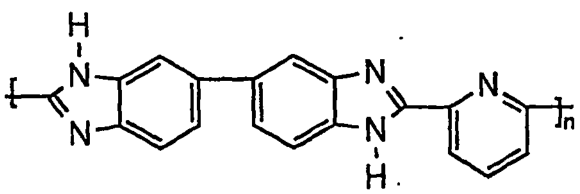

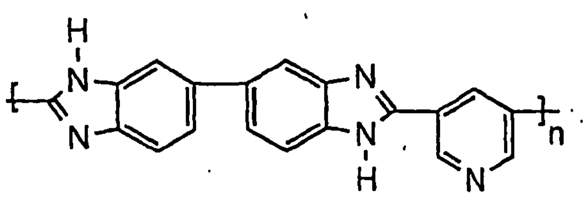

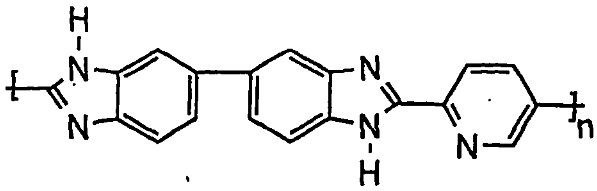

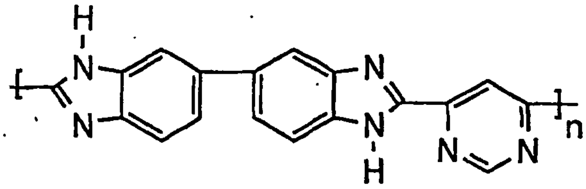

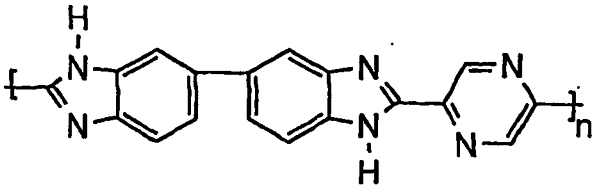

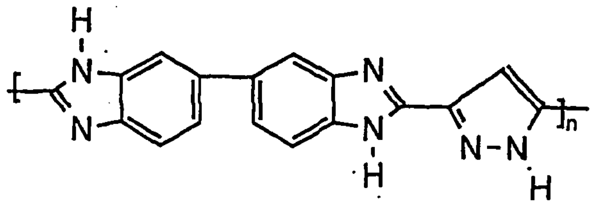

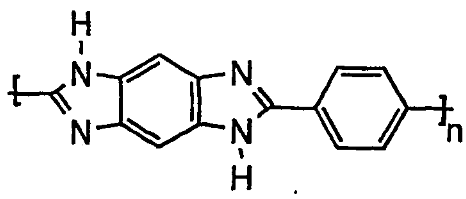

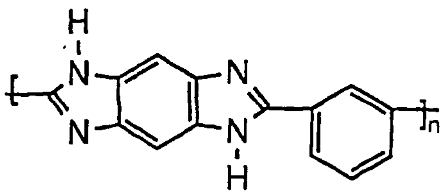

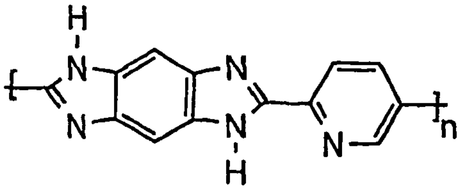

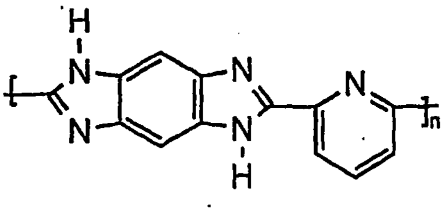

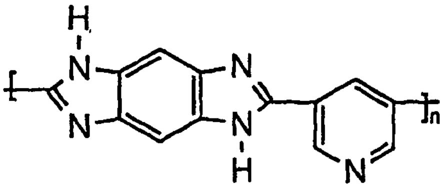

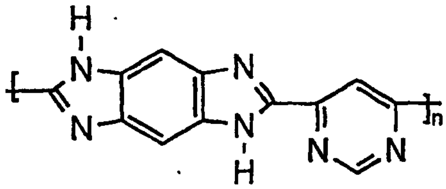

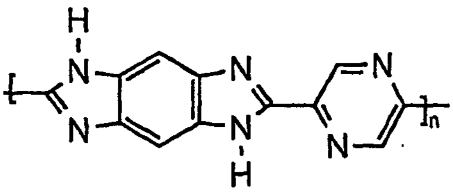

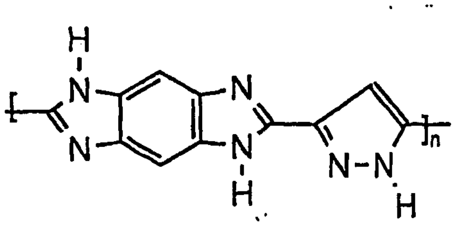

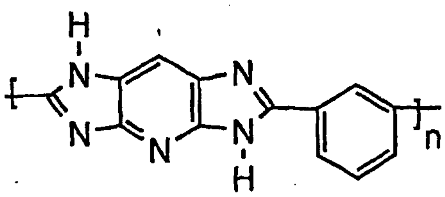

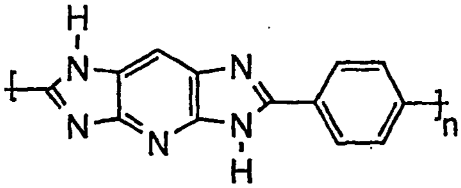

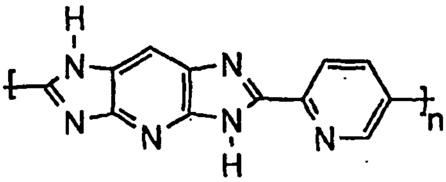

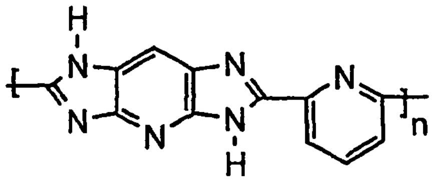

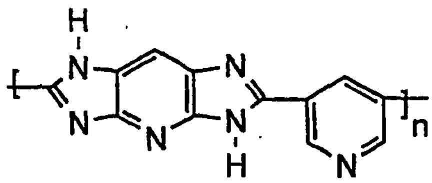

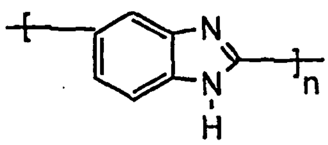

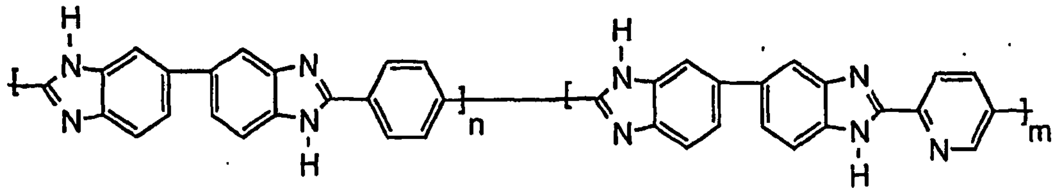

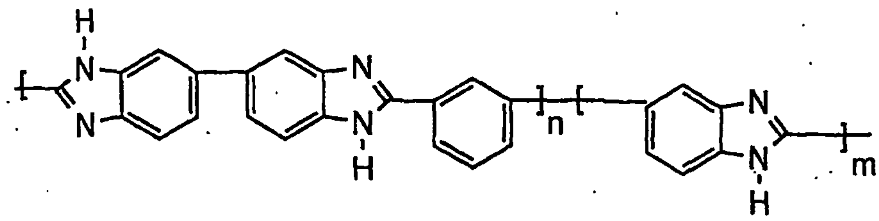

wobei n und m eine ganze Zahl größer gleich 10, vorzugsweise größer gleich 100 ist.

Die mittel des beschriebenen Verfahrens erhältlichen Polyazole, insbesondere jedoch die Polybenzimidazole zeichnen sich durch ein hohes Molekulargewicht aus. Gemessen als Intrinsische Viskosität beträgt diese mindestens 1,4 dl/g vorzugsweise mindestens 1,5 dl/g, und liegt somit deutlich über dem von handelsüblichem Polybenzimidazol (IV < 1,1 dl/g).

Insofern die Mischung gemäß Schritt A) auch zur Vernetzung befähigte Tricarbonsäuren bzw. Tetracarbonsäure enthält wird hierdurch eine Verzweigung/Vernetzung des gebildeten Polymeren erzielt. Diese trägt zur Verbesserung der mechanischen Eigenschaft der gebildeten Membran bei. Insbesondere wird die Membran durch die Vernetzung mittels ggf. vorhandener Tricarbonsäuren bzw. Tetracarbonsäure schneller selbsttragend, wodurch die Behandlung in Schritt D) ggf. verkürzt werden kann. Insofern ein sehr hoher Gehalt an zur Vernetzung befähigten Tricarbonsäuren bzw. Tetracarbonsäure zugegen ist kann auch auf die Nachbehandlung gänzlich verzichtet werden.

Es hat sich weiterhin gezeigt, daß bei Verwendung von aromatischen Dicarbonsäuren (oder heteroaromatischen Dicarbonsäure) wie Isophthalsäure, Terephthalsäure, 2,5-Dihydroxyterephthalsäure, 4,6-Dihydroxyisophthalsäure, 2,6-Dihydroxyisophthalsäure, Diphensäure, 1,8-Dihydroxynaphthalin-3,6-Dicarbonsäure, Diphenylether-4,4.'-Dicarbonsäure, Benzophenon-4,4'-dicarbonsäure, Diphenylsulfon-4,4'-dicarbonsäure, Biphenyl-4,4'-dicarbonsäure, 4-Trifluoromethylphthalsäure, Pyridin-2,5-dicarbonsäure, Pyridin-3,5-dicarbonsäure, Pyridin-2,6-dicarbonsäure, Pyridin-2,4-dicarbonsäure, 4-Phenyl-2,5-pyridindicarbonsäure, 3,5-Pyrazoldicarbonsäure, 2,6 -Pyrimidindicarbonsäure,2,5-Pyrazindicarbonsäure. die Temperatur in Schritt B) im Bereich von bis zu 300°C, vorzugsweise zwischen 100°C und 250°C, günstig ist.

Die Schichtbildung gemäß Schritt C) erfolgt mittels an sich bekannter Maßnahmen (Gießen, Sprühen, Rakeln) die aus dem Stand der Technik zur Polymerfilm-Herstellung bekannt sind.

Als Träger sind insbesondere solche Träger zu verstehen, die unter den gewählten Bedingungen inert sind. Neben diesen inerten Trägern sind jedoch auch Träger aus Polymerfolien geeignet, die nicht inert sind. Aus dieser Gruppe sind Polymerfolien auf Basis von Polyazolen besonders bevorzugt.

Zur Einstellung der Viskosität kann die Lösung gegebenenfalls mit Phosphorsäure (konz. Phosphorsäure, 85%) versetzt werden. Hierdurch kann die Viskosität auf den gewünschten Wert eingestellt und die Bildung der Membran erleichtert werden.

Die gemäß Schritt C) erzeugte Schicht hat eine Dicke zwischen 20 und 4000 µm, vorzugsweise zwischen 30 und 3500 µm, insbesondere zwischen 50 und 3000 µm. Die in Schritt C) vorliegenden intra- und intermolekularen Strukturen führen zu einer geordneten Membranbildung, welche für die besonderen Eigenschaften der gebildeten Membran verantwortlich zeichnet.

Die Behandlung der Membran in Schritt D) bewirkt das diese selbsttragend wird.

Selbsttragend im Sinne der vorliegenden Erfindung bedeutet, daß die gebildete Membran vom Träger ohne Beschädigung abgelöst und anschließend gegebenenfalls direkt weiterverarbeitet werden kann.

Die Nachbehandlung in Schritt D) erfolgt durch Einwirken von Hitze in Gegenwart von Luftsauerstoff. Dies führt zu einer Vernetzung, so daß die Membran selbsttragend wird.

Die Nachbehandlung in Schritt D) kann auch nur durch Einwirken von Hitze erfolgen. Diese Variante wird dann gewählt, wenn die in Schritt B) gewählte Temperatur nicht bereits vorhandene Tri- oder Tetracarbonsäuren vernetzt hat oder vollständig vernetzt hat. Der Temperaturbereich wird zwischen 220°C und 400°C, vorzugsweise zwischen 250°C

und 380°C gewählt. Die Behandlungsdauer beträgt zwischen 5 Sekunden und 10 Stunden.

Eine andere Form der Nachbehandlung in Schritt D) kann durch Behandlung mit Schwefelsäure, insbesondere verdünnter Schwefelsäure, erfolgen. Die Behandlung ist bei der Herstellung von Polybenzimidazol-Fasern für Schutzbekleidung bekannt. Hierzu wird die zu behandelnde Fläche mit Schwefelsäure bzw. verdünnter Schwefelsäure benetzt und anschließend kurzfristig auf Temperaturen von bis 550°C erhitzt. Die gewährleistet eine Vernetzung der Membran so daß diese selbsttragend wird. Die Behandlungsdauer beträgt zwischen 0,5 Sekunden und 10 Minuten. Üblicherweise erfolgt diese durch in Kontakt bringen mit einer beheizten Oberfläche.

Die Nachbehandlung oder Vernetzung kann auch durch Einwirken von IR bzw. NIR (IR = InfraRot, d. h. Licht mit einer Wellenlänge von mehr als 700 nm; NIR = Nahes IR, d. h. Licht mit einer Wellenlänge im Bereich von ca. 700 bis 2000 nm bzw. einer Energie im Bereich von ca. 0.6 bis 1.75 eV) erfolgen. Eine weitere Methode ist die Bestrahlung mit ß-Strahlen. Die Strahlungsdosis beträgt hierbei zwischen 5 und 200 kGy.

Erfindungsgemäß wird die Konzentration der Phosphorsäure als Mol Säure pro Mol Wiederholungseinheit des Polymers angegeben. Im Rahmen der vorliegenden Erfindung ist eine Konzentration (Mol Phosporsäure bezogen auf eine Wiederholeinheit der Formel (III), d.h. Polybenzimidazol) zwischen 10 und 50, insbesondere zwischen 12 und 40, bevorzugt. Derartig hohe Dotierungsgrade (Konzentrationen) sind durch nachträgliches Dotieren von Polyazolfilmen mit kommerziell erhältlicher ortho-Phosphorsäure nur sehr schwierig bzw. gar nicht zugänglich, da ein Verlust der mechanischen Integrität zu beobachten ist.

Die Mittels des erfindungsgemäße Verfahrens hergestellten Polymermembran weisen verbesserte Materialeigenschaften gegenüber den bisher bekannten dotierten Polymermembranen auf. Insbesondere zeigen sie im Vergleich mit bekannten dotierten Polymermembranen bessere Leistungen. Diese begründet sich insbesondere durch eine verbesserte Protonenleitfähigkeit. Diese beträgt bei Temperaturen von 120°C mindestens 0,1 S/cm, vorzugsweise mindestens 0,11 S/cm, insbesondere mindestens 0,12 S/cm.

Zur weiteren Verbesserung der anwendungstechnischen Eigenschaften können der Membran zusätzlich noch Füllstoffe, insbesondere protonenleitende Füllstoffe, sowie zusätzliche Säuren zugesetzt werden. Die Zugabe kann entweder bei Schritt A oder bei Schritt B) erfolgen oder nach der Polymerisation in Schritt B)

Nicht limitierende Beispiele für Protonenleitende Füllstoffe sind

| | |
|---|---|
| Sulfate wie: | $CsHSO_4$, $Fe(SO_4)_2$, $(NH_4)_3H(SO_4)_2$, $LiHSO_4$, $NaHSO_4$, $KHSO_4$, $RbSO_4$, $LiN_2H_5SO_4$, $NH_4HSO_4$, |
| Phosphate wie | $Zr_3(PO_4)_4$, $Zr(HPO_4)_2$, $HZr_2(PO_4)_3$, $UO_2PO_4.3H_2O$, $H_8UO_2PO_4$, $Ce(HPO_4)_2$, $Ti(HPO_4)_2$, $KH_2PO_4$, $NaH_2PO_4$, $LiH_2PO_4$, $NH_4H_2PO_4$, $CsH_2PO_4$, $CaHPO_4$, $MgHPO_4$, $HSbP_2O_8$. $HSb_3P_2O_{14}$, $H_5Sb_5P_2O_{20}$, |
| Polysäure wie | $H_3PW_{12}O_{40}.nH_2O$ (n=21-29), $H_3S\&V_{12}O_4o.nH_2O$ (n=21-29), $H_xWO_3$, $HSbWO_6$. $H_3PMo_{12}O_{40}$, $H_2Sb_4O_{11}$, $HTaW0_6$, $HNbO_3$ $HTiNbO_5$, $HTiTaO_5$. $HSbTeO_6$, $H_5Ti_4O_9$, $HSbO_3$, $H_2MoO_4$ |
| Selenite und Arsenide wie | $(NH_4)_3H(SeO_4)_2$, $UO_2AsO_4$, $(NH_4)_3H(SeO_4)_2$, $KH_2AsO_4$, $Cs_3H(SeO_4)_2$, $Rb_3H(SeO_4)_2$, |
| Oxide wie | $Al_2O_3$, $Sb_2O_5$, $ThO_2$, $SnO_2$, $ZrO_2$, $M0O_3$ |
| Silikate wie | Zeolithe, Zeolithe($NH_4$+), Schichtsilikate, Gerüstsilikate, H-Natrolite, H-Mordenite, $NH_4$-Analcine, $NH_4$-Sodalite, $NH_4$-Gallate, H- Montmorillonite |
| Säuren wie | $HClO_4$, $SbF_5$ |
| Füllstoffe wie | Carbide, insbesondere SiC, $Si_3N_4$, Fasern, insbesondere Glasfasern, Glaspulvern und/ oder Polymerfasern, bevorzugt auf Basis von Polyazolen. |

Als weiteres kann diese Membran auch perfluorierte Sulfonsäure Additive (0,1-20 wt%, bevorzugt 0,2-15 wo%, ganz bevorzugt 0,2-10 wt%) enthalten. Diese Additive führen zur Leistungsverbesserung, in der Nähe der Kathode zur Erhöhung der Sauerstofflöslichkeit und Sauerstoffdiffusion und zur Verringerung der Adsorbtion von Phosphorsäure und Phosphat zu Platin. (Electrolyte additives for phosphoric acid fuel cells. Gang, Xiao; Hjuler, H. A.; Olsen, C.; Berg, R. W.; Bjerrum, N. J.. Chem. Dep. A, Tech. Univ. Denmark, Lyngby, Den. J. Electrochem. Soc. (1993), 140(4), 896-902 und Perfluorosulfonimide as an additive in phosphoric acid fuel cell. Razaq, M.; Razaq, A.; Yeager, E.; DesMarteau, Darryl D.; Singh, S. Case Cent. Electrochem. Sci., Case West. Reserve Univ., Cleveland, OH, USA. J. Electrochem. Soc. (1989), 136(2), 385-90.)
Nicht limitierende Beispiele für persulfonierte, Additive sind:

Trifluomethansulfonsäure, Kaliumtrifluormethansulfonat, Natriumtrifluormethansulfonat, Lithiumtritluormethansulfonat, Ammoniumtrifluormethansulfonat, Kaliumperfluorohexansulfonat, Natriumperfluorohexansulfonat, Lithiumperfluorohexansulfonat, Ammoniumperfluorohexansulfonat, Perfluorohexansulfonsäure, Kaliumnonafluorbutansulfonat, Natriumnonafluorbutansulfonat, Lithiumnonafluorbutansulfonat, Ammoniumnonafluorbutansulfonat, Cäsiumnonafluorbutansulfonat, Triethylammoniumperfluorohexasulfonat, Perflurosulfoimide und Nafion.

Als weiteres kann die Membran auch Additive enthalten, die die im Betrieb bei der Sauerstoffreduktion erzeugten Peroxidradikale abfangen (primäre Anitoxidanzien) oder zerstören (sekundäre Antioxidanzien) und dadurch wie in JP2001118591 A2 beschrieben Lebensdauer und Stabilität der Membran und Membranelektrodeneinheit verbessern. Die Funktionsweise und molekularen Strukturen solcher Additive sind in F. Gugumus in Plastics Additives, Hanser Verlag, 1990; N.S. Allen, M. Edge Fundamentals of Polymer Degradation and Stability, Elsevier, 1992; oder H. Zweifel, Stabilization of Polymeric Materials, Springer, 1998 beschrieben.
Nicht limitierende Beispiele für solche Additive sind:

Bis(trifluormethyl)nitroxid, 2,2-Diphenyl-1-pikrinylhydrazyl, Phenole, Alkylphenole, sterisch gehinderte Alkylphenole wie zum Beispiel Irganox, aromatische Amine, sterisch gehinderte Amine wie zum Beispiel Chimassorb; sterisch gehinderte Hydroxylamine, sterisch gehinderte Alkylamine, sterisch gehinderte Hydroxylamine, sterisch gehinderte Hydroxylaminether, Phosphite wie zum Beispiel Irgafos, Nitrosobenzol, Methyl.2-nitroso-propan, Benzophenon, Benzaldehyd-tert.-butylnitron, Cysteamin, Melanine, Bleioxide, Manganoxide, Nickeloxide, Cobaltoxide.

Zu möglichen Einsatzgebieten der Mittels des erfindungsgemäßen Verfahrens hergestellten dotierten Polymermembranen gehören unter anderem die Verwendung in Brennstoffzellen, bei der Elektrolyse, in Kondensatoren und in Batteriesystemen. Aufgrund ihres Eigenschaftsprofils werden die dotierten Polymermembranen vorzugsweise in Brennstoffzellen verwendet.

Mittels des erfindungsgemäßen Verfahrens hergestellten Membranen eignen sich auch für eine Membran-Elektroden-Einheit. Für weitere Informationen über Membran-Elektroden-Einheiten wird auf die Fachliteratur, insbesondere auf die Patente US-A-4,191,618, US-A-4,212,714 und US-A-4,333,805 verwiesen. Die vorstehend genannten Literaturstellen [US-A-4,191,618, US-A-4,212,714 und US-A-4,333,805] enthalten Offenbarung hinsichtlich des Aufbaues und der Herstellung von Membran-Elektroden-Einheiten, sowie der zu wählenden Elektroden , Gasdiffusionslagen und Katalysatoren.

In einer Variante der vorliegenden Erfindung kann die Membranbildung in Schritt C) anstelle auf einem Träger auch direkt auf der Elektrode erfolgen. Die Behandlung gemäß Schritt D) kann hierdurch entsprechend verkürzt werden, da die Membran nicht mehr zwingend selbsttragend sein muß.

Die Beschichtung hat nach Schritt C) eine Dicke zwischen. 2 und 3000 μm, vorzugsweise zwischen 3 und 2000 μm, Insbesondere zwischen 5 und 1500 μm hat.

Die Nachbehandlung in Schritt D) erfolgt zum Zwecke der vollständigen Polymerisation von ggf. noch vorhandenen Oligomeren.

Eine derartig beschichtete Elektrode kann in einer Membran-Elektroden-Einheit, die gegebenenfalls mindestens eine Polymermembran aufweist, eingebaut werden.

In einer weiteren Variante des Verfahrens kann auf die Membran eine katalytisch aktive Schicht aufgebracht werden und diese mit einer Gasdiffusionslage verbunden werden. Hierzu wird gemäß den Schritten A) bis D) eine Membran gebildet und der Katalysator aufgebracht.

Darüber hinaus kann die Bildung der Membran gemäß den Schritten A) bis D) auch auf einem Träger oder einer Trägerfolie erfolgen, die bereits den Katalysator aufweist. Nach Entfernen des Trägers bzw. der Trägerfolie befindet sich der Katalysator auf der erfindungsgemäßen Membran.

Allgemeine Messmethoden:

Messmethode für IEC

Die Leitfähigkeit der Membran hängt stark vom Gehalt an Säuregruppen ausgedrückt durch die sog. Inenaustauschkapazität (IEC) ab. Zur Messung der Ionenaustauschkapazität wird eine Probe mit einem Durchmesser von 3 cm ausgestanzt und in ein mit 100 ml Wasser gefülltes Becherglas gegeben. Die freigesetzte Säure wird mit 0,1 M NaOH titriert. Anschliessend wird die Probe entnommen, überschüssiges Wasser abgetupft und die Probe bei 160°C während 4h getrocknet. Dann bestimmt man das Trockengewicht, $m_0$, gravimetrisch mit einer Genauigkeit von 0,1 mg. Die Ionenaustauschkapazität wird dann aus dem Verbrauch der 0,1M NaOH bis zum ersten Titrationsendpunkt, $V_1$ in ml, und dem Trockengewicht, $m_0$ in mg, gemäss folgender Formel berechnet:

$$IEC=V_1*300/m_0$$

Messmethode für spezifische Leitfähigkeit

Die spezifische Leitfähigkeit wird mittels Impedanzspektroskopie in einer 4-Pol-Anordnung im potentiostatischen Modus und unter Verwendung von Platinelektroden (Draht, 0,25 mm Durchmesser) gemessen. Der Abstand zwischen den stromabnehmenden Elektroden beträgt 2 cm. Das erhaltene Spektrum wird mit einem einfachen Modell bestehend aus einer parallelen Anordnung eines ohm schen Widerstandes und eines Kapazitators ausgewertet. Der Probenquerschnitt der phosphorsäuredotierten Membran wird unmittelbar vor der Probenmontage gemessen. Zur Messung der Temperaturabhängigkeit wird die Messzelle in einem Ofen auf die gewünschte Temperatur gebracht und über eine in unmittelbarer Probennähe positioniertes Pt-100 Thermoelement geregelt. Nach Erreichen der Temperatur wird die Probe vor dem Start der Messung 10 Minuten auf dieser Temperatur gehalten

**Patentansprüche**

1. **1.** Verfahren zur Herstellung einer protonenleitenden Polymermembran auf Basis von Polyazolen umfassend die Schritte

   A) Mischen von einem oder mehreren aromatischen Tetra-Amino-Verbindungen mit einer oder mehreren aromatischen Carbonsäuren bzw. deren Estern, die mindestens zwei Säuregruppen pro Carbonsäure-Monomer enthalten, oder Mischen von einer oder mehreren aromatischen und/oder heteroaromatischen Diaminocarbonsäuren, in Phosphorsäure mit einer Konzentration von 85% und mehr, die keine Polyphosphorsäure der Formel $H_{n+2}P_nO_{3n+1}$ ($n \geq 2$) aufweist, unter Ausbildung einer Lösung und/oder Dispersion,
   B) Erwärmen der gemäß Schritt A) erhaltenen Lösung und/oder Dispersion auf Temperaturen von bis zu 350°C, vorzugsweise bis zu 280°C unter Ausbildung des Polyazol-Polymeren,
   C) Aufbringen einer Schicht unter Verwendung der Mischung gemäß Schritt B) auf einem Träger,
   D) Behandlung der in Schritt C) gebildeten Membran.

**2.** Verfahren gemäß Anspruch 1, **dadurch gekennzeichnet, daß** als aromatische Tetra-Amino-Verbindungen 3,3', 4,4'-Tetraaminobiphenyl, 2,3,5,6-Tetraaminopyridin, 1,2,4,5-Tetraaminobenzol, 3,3',4,4'-Tetraaminodiphenylsulfon, 3,3',4,4'-Tetraaminodiphenylether, 3,3',4,4'-Tetraaminobenzophenon, 3,3',4,4'-Tetraaminodiphenylmethan und 3,3',4,4'-Tetraaminodiphenyldimethylmethan

**3.** Verfahren gemäß Anspruch 1, **dadurch gekennzeichnet, daß** als aromatische Dicarbonsäuren Isophthalsäure, Terephthalsäure, Phthalsäure, 5-Hydroxyisophthalsäure, 4-Hydroxyisophthalsäure, 2-Hydroxyterephthalsäure, 5-Aminoisophthalsäure, 5-N,N-Dimethylaminoisophthalsäure, 5-N,N-Diethylaminoisophthalsäure, 2,5-Dihydroxyterephthalsäure, 2,5-Dihydroxyisophthalsäure, 2,3-Dihydroxyisophthalsäure, 2,3-Dihydroxyphthalsäure, 2,4-Dihydroxyphthalsäure. 3,4-Dihydroxyphthalsäure, 3-Fluorophthalsäure, 5-Fluoroisophthalsäure, 2-Fluoroterphthalsäure, Tetrafluorophthalsäure, Tetrafluoroisophthalsäure, Tetrafluoroterephthalsäure, 1,4-Naphthalindicarbonsäure, 1,5-Naphthalindicarbonsäure, 2,6-Naphthalindicarbonsäure, 2,7-Naphthalindicarbonsäure, Diphensäure, 1,8-dihydroxynaphthalin-3,6-dicarbonsäure, Diphenylether-4,4'-dicarbonsäure, Benzophenon-4,4'-dicarbonsäure, Diphenylsulfon-4,4'-dicarbonsäure, Biphenyl-4,4'-dicarbonsäure, 4-Trifluoromethylphthalsäure, 2,2-Bis(4-carboxyphenyl) hexafluoropropan, 4,4'-Stilbendicarbonsäure, 4-Carboxyzimtsäure, bzw. deren C1-C20-Alkyl-Ester oder C5-C12-Aryl-Ester, oder deren Säureanhydride oder deren Säurechloride eingesetzt werden.

**4.** Verfahren gemäß Anspruch 1, **dadurch gekennzeichnet, daß** als aromatische Carbonsäure Tri-carbonsäuren, Tetracarbonsäuren bzw. deren C1-C20-Alkyl-Ester oder C5-C12-Aryl-Ester oder deren Säureanhydride oder deren Säurechloride, vorzugsweise 1,3,5-benzene-tricarboxylic acid (trimesic acid); 1,2,4-benzene-tricarboxylic acid (trimellitic acid); (2-Carboxyphenyl)iminodiessigsäure, 3,5,3'-biphenyltricarboxylic acid; 3,5,4'-biphenyltricarboxylic acid und/oder 2,4,6-pyridinetricarboxylic acid eingesetzt werden.

**5.** Verfahren gemäß Anspruch 1, **dadurch gekennzeichnet, daß** als aromatische Carbonsäure Tetracarbonsäuren deren C1-C20-Alkyl-Ester oder C5-C12-Aryl-Ester oder deren Säureanhydride oder deren Säurechloride, vorzugsweise Benzol 1,2,4,5-tetracarbonsäuren; Naphthalin-1,4,5,8-tetracarbonsäuren 3,5,3',5'-biphenyltetracarboxylic acid; Benzophenontetracarbonsäure, 3,3',4,4'-Biphenyltetracarbonsäure, 2,2',3,3'-Biphenyltetracarbonsäure, 1,2,5,6-Naphthalintetracarbonsäure, 1,4,5,8-Naphthalintetracarbonsäure eingesetzt werden.

**6.** Verfahren gemäß Anspruch 4, **dadurch gekennzeichnet, daß** der Gehalt an Tri-carbonsäure bzw. Tetracarbonsäuren (bezogen auf eingesetzte Dicarbonsäure) beträgt zwischen 0,5 und 20 Mol % beträgt.

7. Verfahren gemäß Anspruch 1, **dadurch gekennzeichnet, daß** als heteroaromatische Carbonsäuren heteroaromatische Di-carbonsäuren und Tri-carbonsäuren und Tetra-Carbonsäuren eingesetzt werden, welche mindestens ein Stickstoff, Sauerstoff, Schwefel oder Phosphoratom im Aromaten enthalten, vorzugsweise Pyridin-2,5-dicarbonsäure, Pyridin-3,5-dicarbonsäure, Pyridin-2,6-dicarbonsäure, Pyridin-2,4-dicarbonsäure, 4-Phenyl-2,5-pyridindicarbonsäure, 3,5-Pyrazoldicarbonsäure, 2,6-Pyrimidindicarbonsäure,2,5-Pyrazindicarbonsäure, 2,4,6-Pyridintricarbonsäure, Benzimidazol-5,6-dicarbonsäure, sowie deren C1-C20-Alkyl-Ester oder C5-C12-Aryl-Ester, oder deren Säureanhydride oder deren Säurechloride.

8. Verfahren gemäß Anspruch 1, **dadurch gekennzeichnet, daß** in Schritt B) ein Polymere auf Basis von Polyazol enthält wiederkehrende Azoleinheiten der allgemeinen Formel (I) und/ oder (II) und/oder (III) und/oder (IV) und/oder (V) und/oder (VI) und/oder (VII) und/oder (VIII) und/oder (IX) und/oder (X) und/oder (XI) und/oder (XII) und/oder (XIII) und/oder (XIV) und/oder (XV) und/oder (XVI) und/oder (XVII) und/oder (XVIII) und/oder (XIX) und/oder (XX) und/oder (XXI) und/oder (XXII)

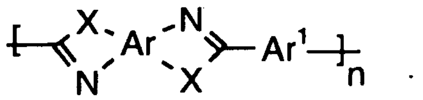

(I)

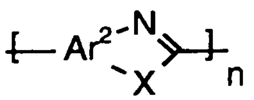

(II)

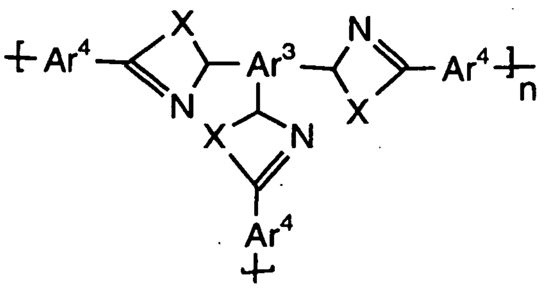

(III)

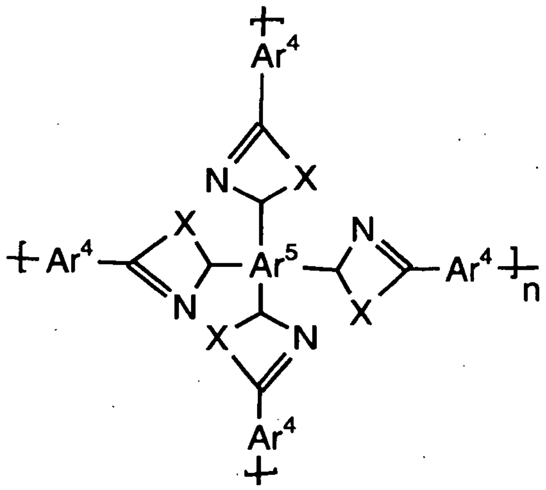

(IV)

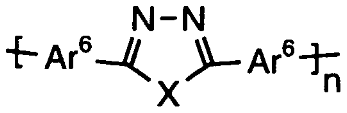

(V)

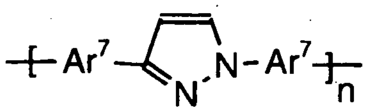

(VI)

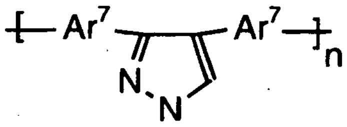

(VII)

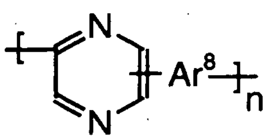

(VIII)

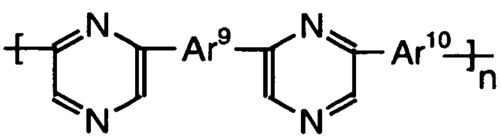

(IX)

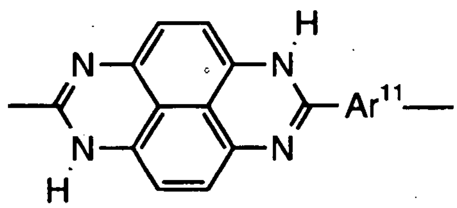

(X)

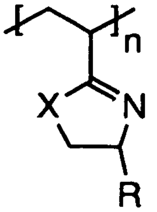

(XI)

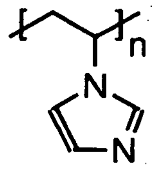

(XII)

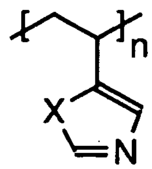

(XIII)

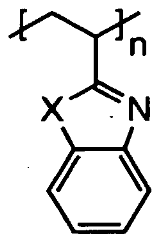

(XIV)

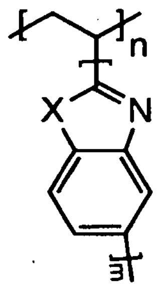

(XV)

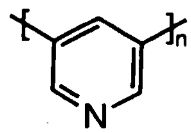

(XVI)

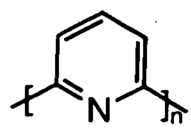

(XVII)

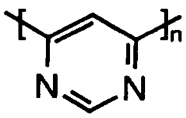

(XVIII)

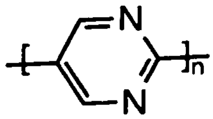

(XIX)

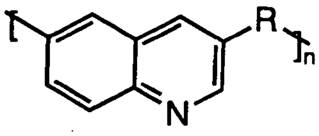

(XX)

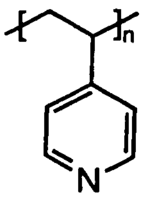

(XXI)

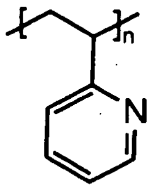

(XXII)

worin

Ar gleich oder verschieden sind und für eine vierbindige aromatische oder heteroaromatische Gruppe, die ein- oder mehrkernig sein kann,

$Ar^1$ gleich oder verschieden sind und für eine zweibindige aromatische oder heteroaromatische Gruppe, die ein- oder mehrkernig sein kann,

$Ar^2$ gleich oder verschieden sind und für eine zwei oder dreibindige aromatische oder heteroaromatische Gruppe, die ein- oder mehrkernig sein kann,

$Ar^3$ gleich oder verschieden sind und für eine dreibindige aromatische oder heteroaromatische Gruppe, die ein- oder mehrkernig sein kann,

$Ar^4$ gleich oder verschieden sind und für eine dreibindige aromatische oder heteroaromatische Gruppe, die ein- oder mehrkernig sein kann,

$Ar^5$ gleich oder verschieden sind und für eine vierbindige aromatische oder heteroaromatische Gruppe, die ein- oder mehrkernig sein kann,

$Ar^6$ gleich oder verschieden sind und für eine zweibindige aromatische oder heteroaromatische Gruppe, die

ein- oder mehrkernig sein kann,
$Ar^7$ gleich oder verschieden sind und für eine zweibindige aromatische oder heteroaromatische Gruppe, die ein- oder mehrkernig sein kann,
$Ar^8$ gleich oder verschieden sind und für eine dreibindige aromatische oder heteroaromatische Gruppe, die ein- oder mehrkernig sein kann,
$Ar^9$ gleich oder verschieden sind und für eine zwei- oder drei- oder vierbindige aromatische oder heteroaromatische Gruppe, die ein- oder mehrkernig sein kann,
$Ar^{10}$ gleich oder verschieden sind und für eine zwei- oder dreibindige aromatische oder heteroaromatische Gruppe, die ein- oder mehrkernig sein kann,
$Ar^{11}$ gleich oder verschieden sind und für eine zweibindige aromatische oder heteroaromatische Gruppe, die ein- oder mehrkernig sein kann,
X gleich oder verschieden ist und für Sauerstoff, Schwefel oder eine Aminogruppe, die ein Wasserstoffatom, eine 1- 20 Kohlenstoffatome aufweisende Gruppe, vorzugsweise eine verzweigte oder nicht verzweigte Alkyl- oder Alkoxygruppe, oder eine Arylgruppe als weiteren Rest trägt
R gleich oder verschieden für Wasserstoff, eine Alkylgruppe und eine aromatische Gruppe steht und R in Formel (XX) für eine Alkylgruppe und eine aromatische Gruppe steht,
n, m eine ganze Zahl größer gleich 10, bevorzugt größer gleich 100 ist, gebildet wird.

**9.** Verfahren gemäß Anspruch 1, **dadurch gekennzeichnet, daß** in Schritt B) ein Polymer ausgewählt aus der Gruppe Polybenzimidazol, Poly(pyridine), Poly(pyrimidine), Polyimidazole, Polybenzthiazole, Polybenzoxazole, Polyoxadiazole, Polyquinoxalines, Polythiadiazole und Poly(tetrazapyrene) gebildet wird.

**10.** Verfahren gemäß Anspruch 1, **dadurch gekennzeichnet, daß** in Schritt B) ein Polymer enthaltend wiederkehrende Benzimidazoleinheiten der Formel

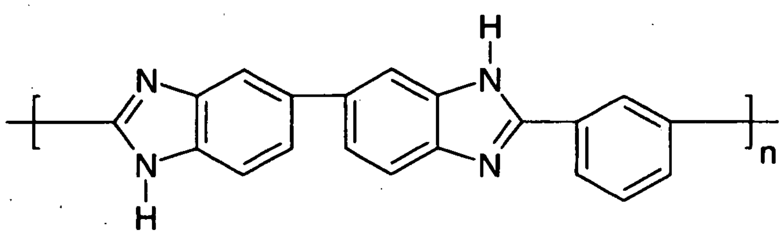

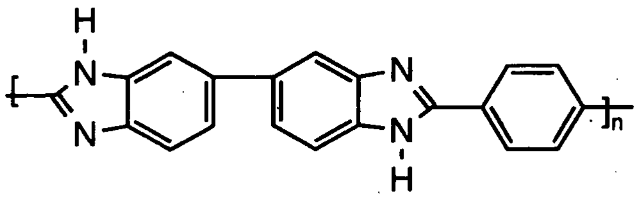

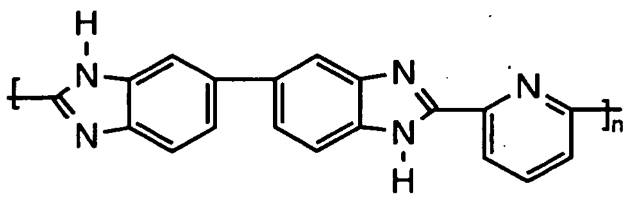

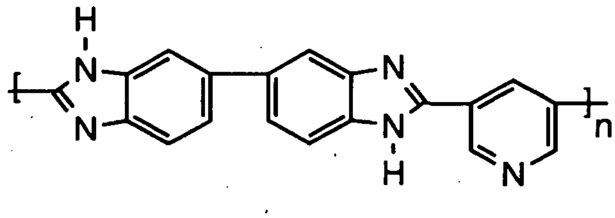

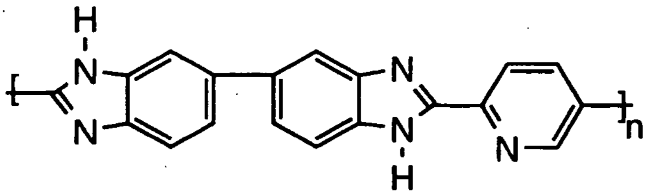

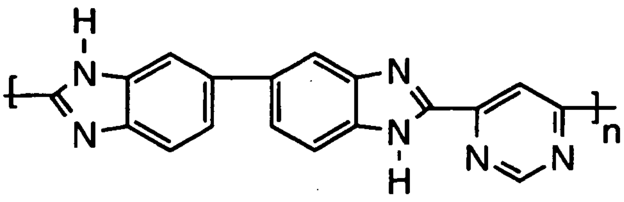

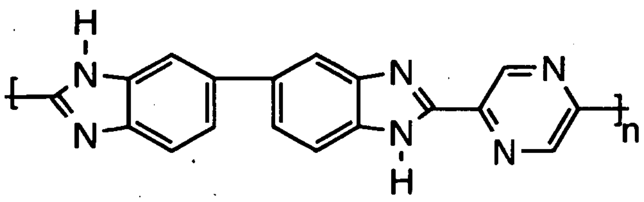

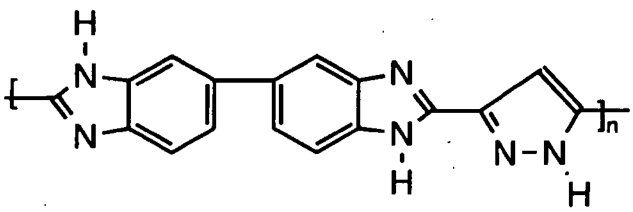

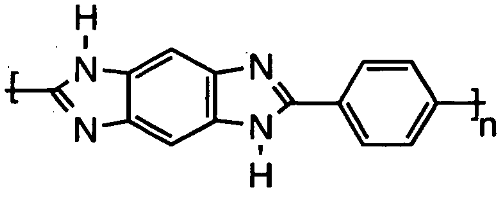

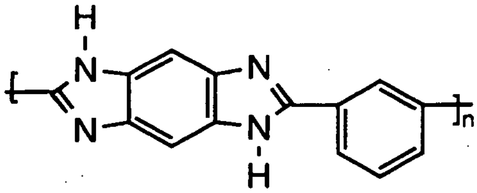

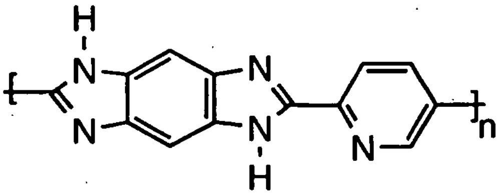

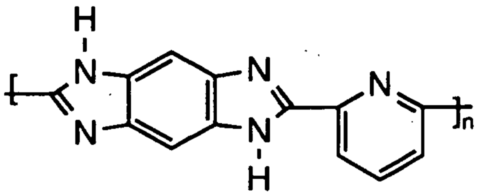

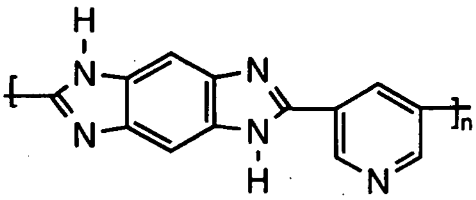

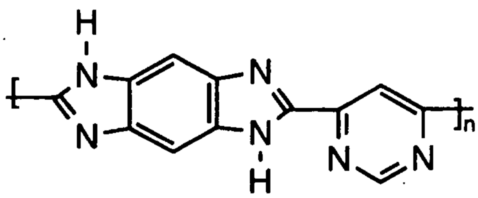

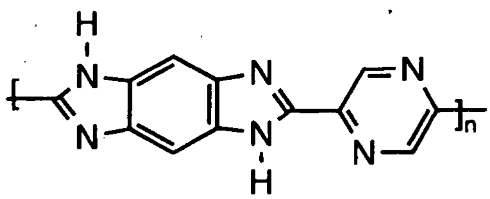

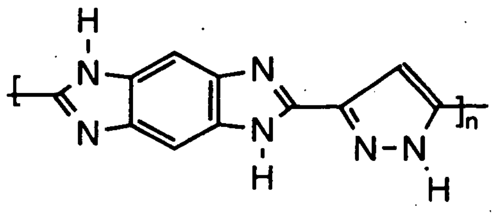

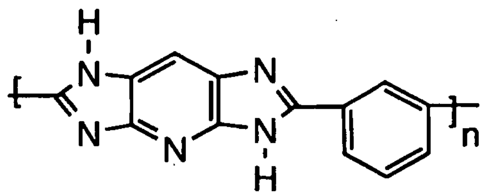

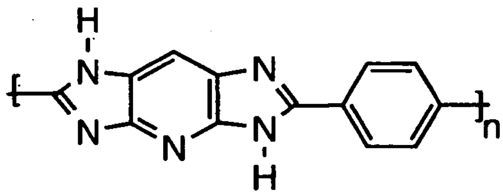

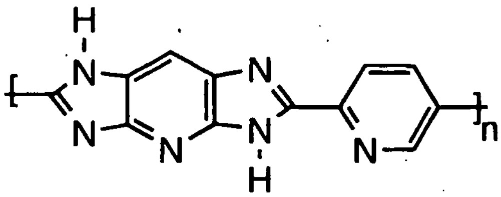

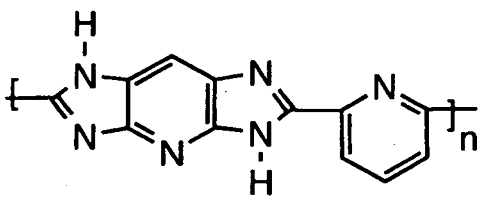

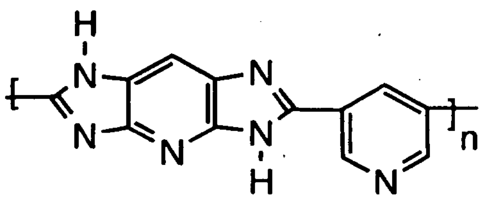

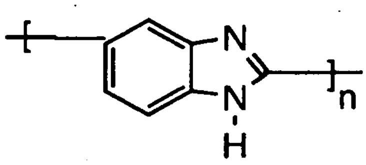

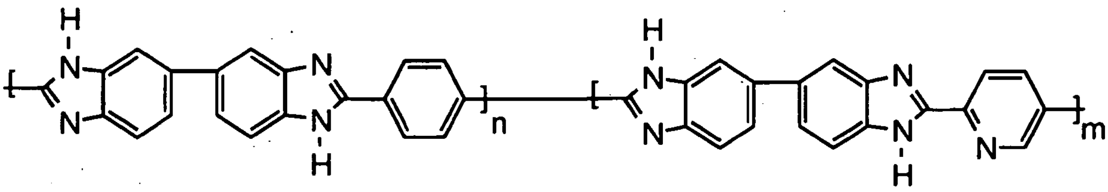

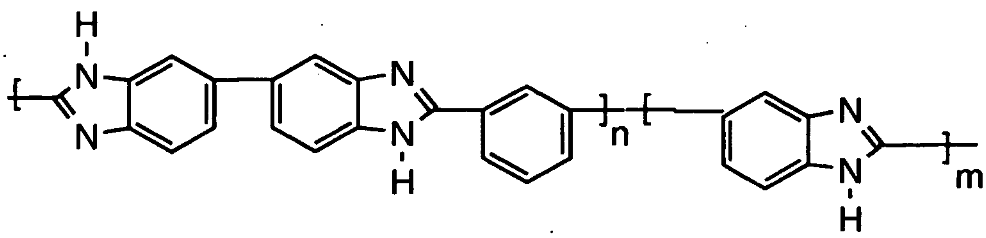

wobei n und m eine ganze Zahl größer gleich 10, vorzugsweise größer gleich 100 ist, gebildet wird.

**11.** Verfahren gemäß Anspruch 1, **dadurch gekennzeichnet, daß** nach Schritt B) und vor Schritt C) die Viskosität durch Zugabe von Phosphorsäure eingestellt wird.

**12.** Verfahren gemäß Anspruch 1, **dadurch gekennzeichnet, daß** in Schritt C) eine Schicht mit einer Dicke von 20 und 4000 µm, vorzugsweise zwischen 30 und 3500 µm, insbesondere zwischen 50 und 3000 µm erzeugt wird.

**13.** Verfahren gemäß Anspruch 1, **dadurch gekennzeichnet, daß** die gemäß Schritt C) erzeugte Membran in Schritt D) behandelt wird bis die Membran selbsttragend ist und ohne Beschädigung vom Träger abgelöst werden kann.

**14.** Verfahren gemäß Anspruch 1, **dadurch gekennzeichnet, daß** die gemäß Schritt C) erzeugte Membran in Schritt D) durch Einwirken von Hitze in Gegenwart von Luftsauerstoff behandelt wird.

**15.** Verfahren gemäß Anspruch 1, **dadurch gekennzeichnet, daß** die gemäß Schritt C) erzeugte Membran noch Tri- oder Tetracarbonsäuren enthält, welche in Schritt D) vernetzt werden.

16. Verfahren gemäß Anspruch 1, **dadurch gekennzeichnet, daß** die gemäß Schritt C) erzeugte Membran in Schritt D) durch Behandlung mit Schwefelsäure vernetzt wird.

17. Verfahren gemäß Anspruch 1, **dadurch gekennzeichnet, daß** die gemäß Schritt C) erzeugte Membran in Schritt D) durch Einwirken von IR bzw. NIR Licht oder durch Bestrahlung mit ß-Strahlen vernetzt wird.

18. Verfahren gemäß Anspruch 1, **dadurch gekennzeichnet, daß** die gemäß Schritt D) erzeugte Membran mit einer katalytisch aktiven Schicht versehen wird.

19. Verfahren gemäß Anspruch 1, **dadurch gekennzeichnet, daß** die Bildung der Membran gemäß den Schritten A) bis D) auf einem Träger oder einer Trägerfolie erfolgen, die bereits den Katalysator aufweist und nach Entfernen des Trägers bzw. der Trägerfolie sich der Katalysator auf der erfindungsgemäßen Membran befindet

20. Verfahren gemäß Anspruch 1, **dadurch gekennzeichnet, daß** die Bildung der Membran gemäß den Schritten A) bis D) auf einer Elektrode als Träger erfolgt.

21. Verfahren gemäß Anspruch 20, wobei die gebildete Membranschicht eine Dicke zwischen 2 und 3000 μm, vorzugsweise zwischen 3 und 2000 μm, insbesondere zwischen 5 und 1500 μm hat.

**Claims**

1. Process for manufactring of a proton-conducting polymer membrane which is based on polyazoles comprising the steps

   A) mixing of one or more aromatic tetraamino compounds with one or more aromatic carboxylic acids or esters thereof which contain at least two acid groups per carboxylic acid monomer, or mixing of one or more aromatic and/or heteroaromatic diaminocarboxylic acids, in phosphoric acid having a concentration of 85% and more, said phosphonic acid does not contain polyphosphonic acid of the formula $H_{n+2}P_nO_{3n+1}$ (n≥2), to form a solution and/or dispersion,
   B) heating of the solution and/or dispersion obtained in step A) to temperatures of up to 350°C, preferably up to 280°C, to form the polyazole polymer,
   C) application of a layer using the mixture from step B) to a support,
   D) treatment of the membrane formed in step C).

2. The process as claimed in claim 1, **characterized in that** 3,3',4,4'-tetraaminobiphenyl, 2,3,5,6-tetraaminopyridine, 1,2,4,5-tetraaminobenzene, bis(3,4-diaminophenyl)sulfone, bis(3,4-diaminophenyl) ether, 3,3',4,4'-tetra-aminobenzophenone, 3,3',4,4'-tetraaminodiphenylmethane and 3,3',4,4'-tetraaminodiphenyldimethylmethane are used as aromatic tetraamino compounds.

3. The process as claimed in claim 1, **characterized in that** isophthalic acid, terephthalic acid, phthalic acid, 5-hydroxyisophthalic acid, 4-hydroxyisophthalic acid, 2-hydroxyterephthalic acid, 5-aminoisophthalic acid, 5-N,N-dimethylaminoisophthalic acid, 5-N,N-diethylaminoisophthalic acid, 2,5-dihydroxyterephthalic acid, 2,5-dihydroxyisophthalic acid, 2,3-dihydroxyisophthalic acid, 2,3-dihydroxyphthalic acid, 2,4-dihydroxyphthalic acid, 3,4-dihydroxyphthalic acid, 3-fluorophthalic acid, 5-fluoroisophthalic acid, 2-fluoroterephthalic acid, tetrafluorophthalic acid, tetrafluoroisophthalic acid, tetrafluoroterephthalic acid, 1,4-naphthalenedicarboxylic acid, 1,5-naphthalenedicarboxylic acid, 2,6-naphthalenedicarboxylic acid, 2,7-naphthalenedicarboxylic acid, diphenic acid, 1,8-dihydroxynaphthalene-3,6-dicarboxylic acid, bis(4-carboxyphenyl) ether, benzophenone-4,4'-dicarboxylic acid, bis(4-dicarboxyphenyl) sulfone, biphenyl-4,4'-dicarboxylic acid, 4-trifluoromethylphthalic acid, 2,2-bis(4-carboxyphenyl)hexafluoropropane, 4,4'-stilbenedicarboxylic acid, 4-carboxycinnamic acid, or their C1-C20-alkyl esters or C5-C12-aryl esters, or their acid anhydrides or acid chlorides are used as aromatic dicarboxylic acids.

4. The process as claimed in claim 1, **characterized in that** tricarboxylic acids, tetracarboxylic acids or their C1-C20-alkyl esters or C5-C12-aryl esters or their acid anhydrides or their acid chlorides, preferably 1,3,5-benzenetricarboxylic acid (trimesic acid); 1,2,4-benzenetricarboxylic acid (trimellitic acid); (2-carboxyphenyl)iminodiacetic acid, 3,5,3'-biphenyltricarboxylic acid; 3,5,4'-biphenyltricarboxylic acid and/or 2,4,6-pyridinetricarboxylic acid, are used as aromatic carboxylic acids.

5. The process as claimed in claim 1, **characterized in that** tetracarboxylic acids, their C1-C20-alkyl esters or C5-C12-aryl esters or their acid anhydrides or their acid chlorides, preferably benzene-1,2,4,5-tetracarboxylic acid; naphthalene-1 ,4,5,8-tetracarboxylic acid, 3,5,3',5'-biphenyltetracarboxylic acid; benzophenonetetracarboxylic acid, 3,3',4,4'-biphenyltetracarboxylic acid, 2,2',3,3'-biphenyltetracarboxylic acid, 1,2,5,6-naphthalenetetracarboxylic acid, 1,4,5,8-naphthalenetetracarboxylic acid, are used as aromatic carboxylic acids.

6. The process as claimed in claim 4, **characterized in that** the content of tricarboxylic acids and tetracarboxylic acids (based on dicarboxylic acid used) is from 0.5 to 20 mol%.

7. The process as claimed in claim 1, **characterized in that** heteroaromatic dicarboxylic acids and tricarboxylic acids and tetracarboxylic acids containing at least one nitrogen, oxygen, sulfur or phosphorus atom in the aromatic, preferably pyridine-2,5-dicarboxylic acid, pyridine-3,5-dicarboxylic acid, pyridine-2,6-dicarboxylic acid, pyridine-2,4-dicarboxylic acid, 4-phenyl-2,5-pyridinedicarboxylic acid, 3,5-pyrazoledicarboxylic acid, 2,6-pyrimidine-dicarboxylic acid, 2,5-pyrazinedicarboxylic acid, 2,4,6-pyridinetricarboxylic acid, benzimidazole-5,6-dicarboxylic acid, and their C1-C20-alkyl esters or C5-C12-aryl esters, or their acid anhydrides or their acid chlorides are used as heteroaromatic carboxylic acids.

8. The process as claimed in claim 1, **characterized in that** a polyazole-based polymer comprising recurring azole units of the general formula (I) and/or (II) and/or (III) and/or (IV) and/or (V) and/or (VI) and/or (VII) and/or (VIII) and/or (IX) and/or (X) and/or (XI) and/or (XII) and/or (XIII) and/or (XIV) and/or (XV) and/or (XVI) and/or (XVII) and/or (XVIII) and/or (XIX) and/or (XX) and/or (XXI) and/or (XXII)

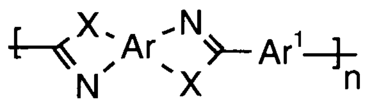

(I)

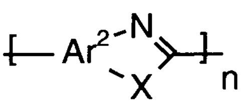

(II)

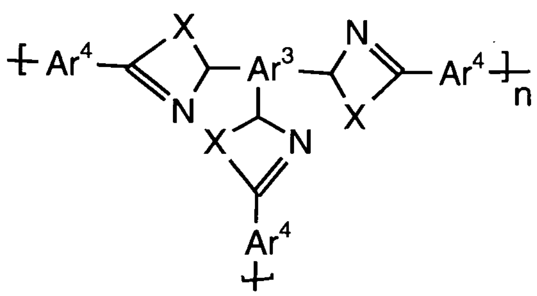

(III)

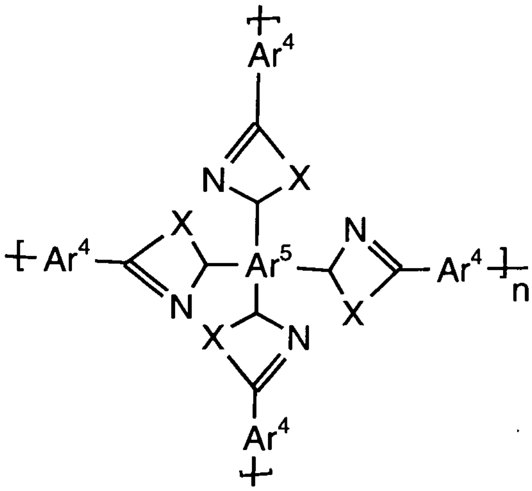

(IV)

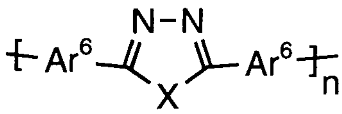

(V)

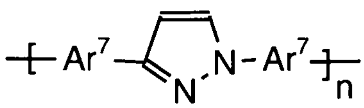

(VI)

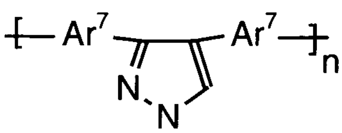

(VII)

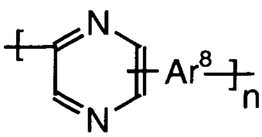

(VIII)

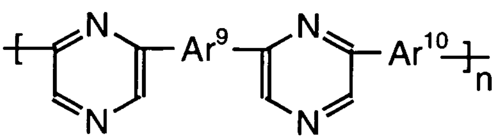

(IX)

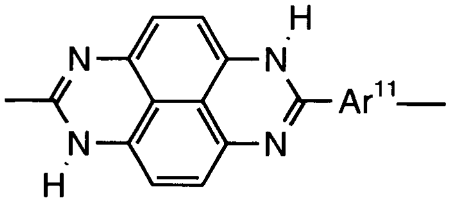

(X)

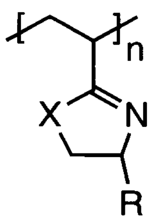

(XI)

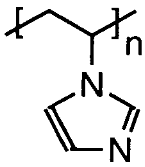

(XII)

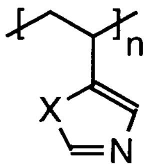

(XIII)

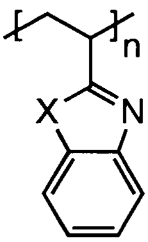

(XIV)

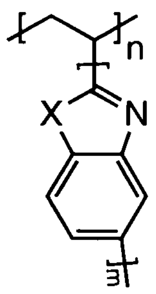

(XV)

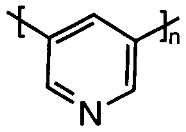

(XVI)

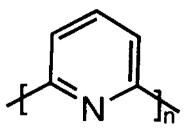

(XVII)

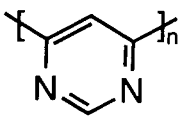

(XVIII)

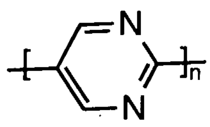

(XIX)

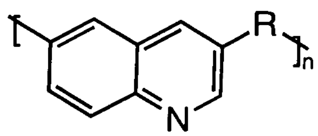

(XX)

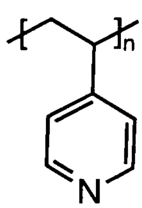

(XXI)

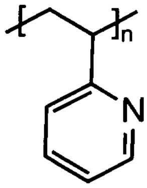

(XXII)

where

the radicals Ar are identical or different and are each a tetravalent aromatic or heteroaromatic group which can be monocyclic or poly- cyclic,
the radicals $Ar^1$ are identical or different and are each a divalent aromatic or heteroaromatic group which can be monocyclic or polycyclic,
the radicals $Ar^2$ are identical or different and are each a divalent or trivalent aromatic or heteroaromatic group which can be monocyclic or polycyclic,
the radicals $Ar^3$ are identical or different and are each a trivalent aromatic or heteroaromatic group which can be monocyclic or polycyclic,
the radicals $Ar^4$ are identical or different and are each a trivalent aromatic or heteroaromatic group which can be monocyclic or polycyclic,
the radicals $Ar^5$ are identical or different and are each a tetravalent aromatic or heteroaromatic group which can be monocyclic or poly- cyclic,
the radicals $Ar^6$ are identical or different and are each a divalent aromatic or heteroaromatic group which can be monocyclic or polycyclic,
the radicals $Ar^7$ are identical or different and are each a divalent aromatic or heteroaromatic group which can be monocyclic or polycyclic,
the radicals $Ar^8$ are identical or different and are each a trivalent aromatic or heteroaromatic group which can be monocyclic or polycyclic,
the radicals $Ar^9$ are identical or different and are each a divalent or trivalent or tetravalent aromatic or heteroaromatic group which can be monocyclic or polycyclic,
the radicals $Ar^{10}$ are identical or different and are each a divalent or trivalent aromatic or heteroaromatic group which can be monocyclic or polycyclic,
the radicals $Ar^{11}$ are identical or different and are each a divalent aromatic or heteroaromatic group which can be monocyclic or polycyclic,
the radicals X are identical or different and are each oxygen, sulfur or an amino group which bears a hydrogen atom, a group having 1- 20 carbon atoms, preferably a branched or unbranched alkyl or alkoxy group, or an aryl group as further radical,
the radicals R are identical or different and are each hydrogen, an alkyl group or an aromatic group and R in formula (XX) is an alkyl group and an aromatic group,
n, m are each an integer greater than or equal to 10, preferably greater than or equal to 100,

is formed in step B).

**9.** The process as claimed in claim 1, **characterized in that** a polymer selected from the group consisting of polybenzimidazole, poly(pyridines), poly(pyrimidines), polyimidazoles, polybenzothiazoles, polybenzoxazoles, polyoxadiazoles, polyquinoxalines, polythiadiazoles and poly(tetrazapyrenes) is formed in step B).

**10.** The process as claimed in claim 1, **characterized in that** a polymer comprising recurring benzimidazole units of the formula

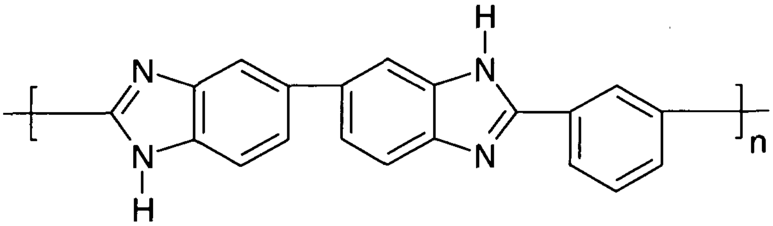

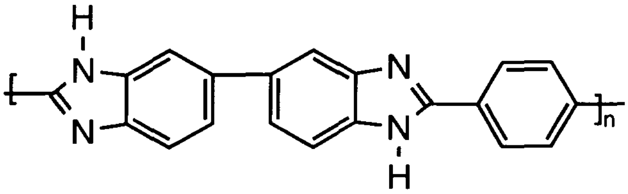

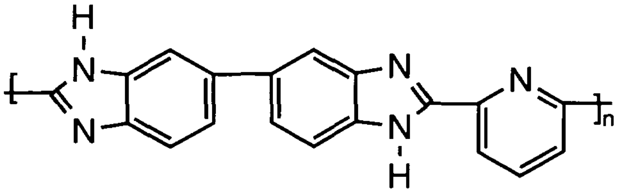

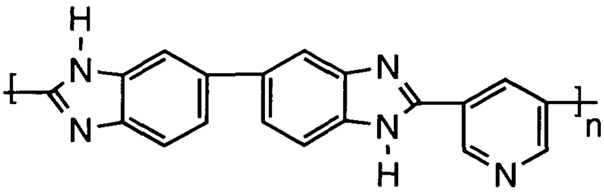

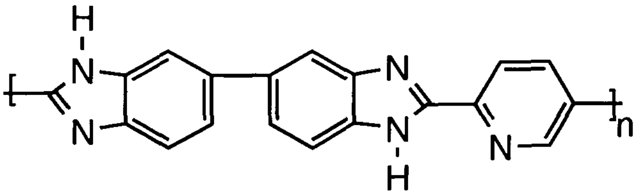

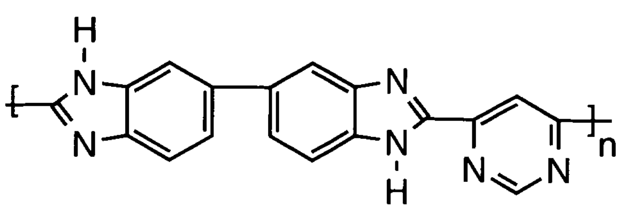

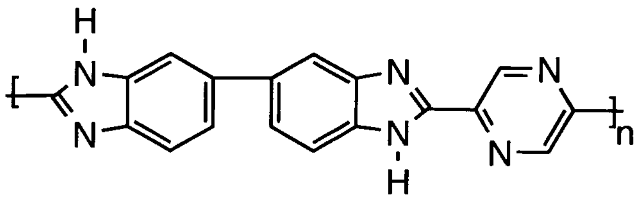

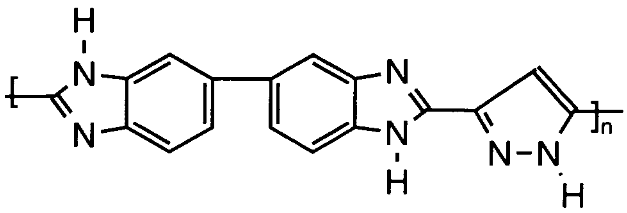

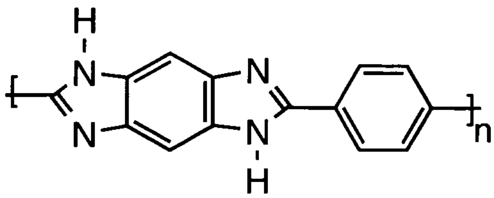

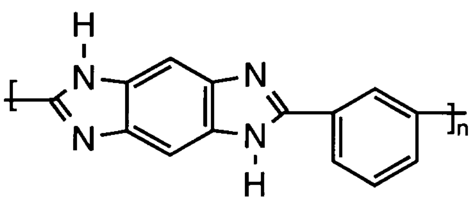

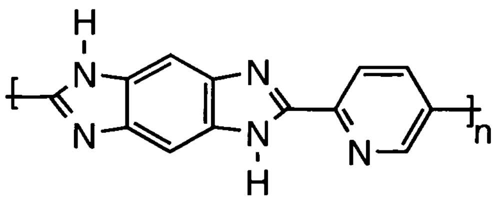

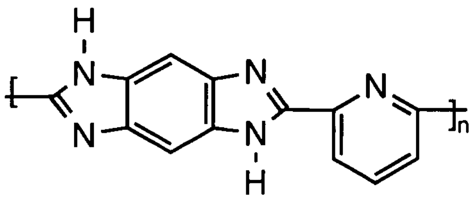

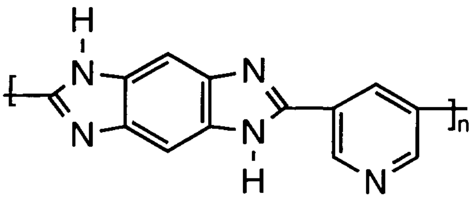

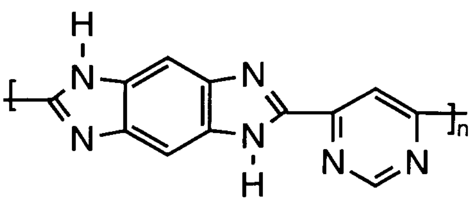

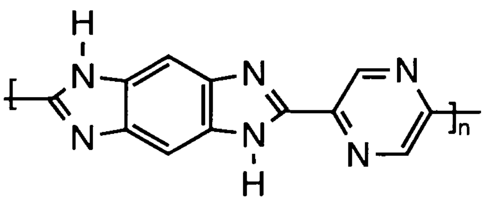

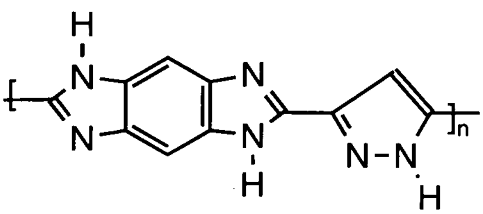

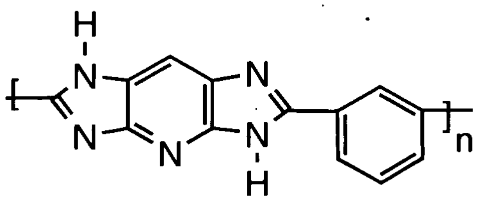

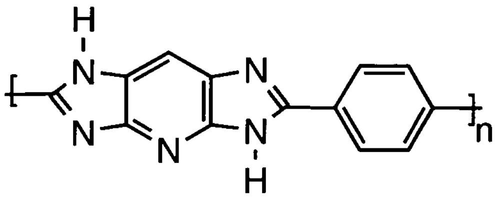

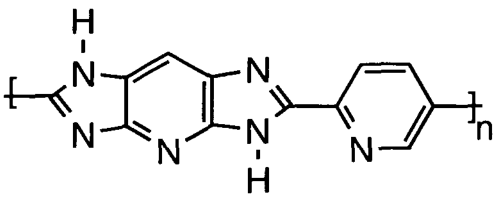

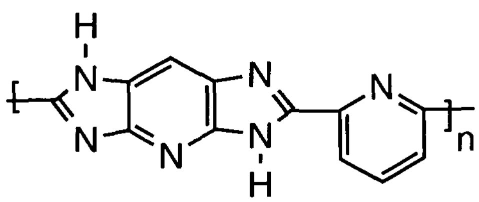

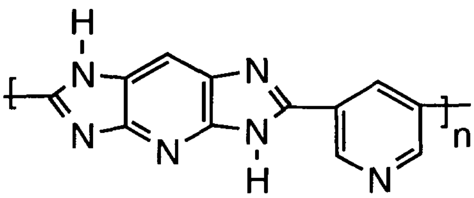

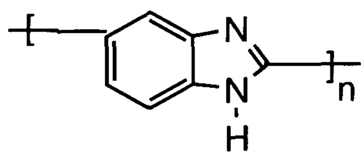

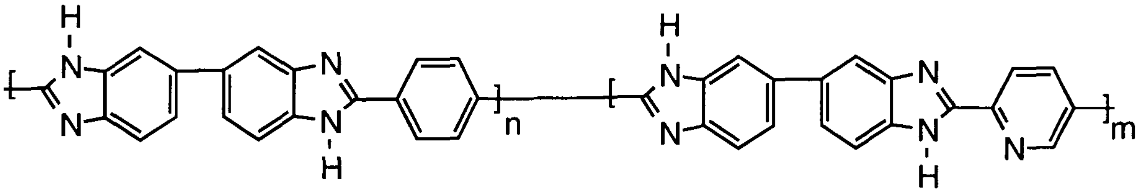

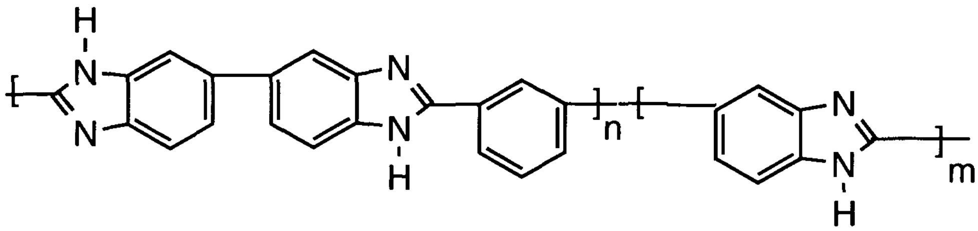

where n and m are each an integer greater than or equal to 10, preferably greater than or equal to 100, is formed in step B).

**11.** The process as claimed in claim 1, **characterized in that** the viscosity is adjusted by addition of phosphoric acid after step B) and before step C).

**12.** The process as claimed in claim 1, **characterized in that** a layer having a thickness of from 20 to 4000 μm, preferably from 30 to 3500 μm, in particular from 50 to 3000 μm, is produced in step C).

**13.** The process as claimed in claim 1, **characterized in that** the membrane produced in step C) is treated in step D) until the membrane is self-supporting and can be detached from the support without damage.

**14.** The process as claimed in claim 1, **characterized in that** the membrane produced in step C) is treated in step D) by the action of heat in the presence of atmospheric oxygen.

**15.** The process as claimed in claim 1, **characterized in that** the membrane produced in step C) still contains tricarboxylic or tetracarboxylic acids which are crosslinked in step D).

**16.** The process as claimed in claim 1, **characterized in that** the membrane produced in step C) is crosslinked by treatment with sulfuric acid in step D).

**17.** The process as claimed in claim 1, **characterized in that** the membrane produced in step C) is crosslinked by action of IR or NIR light or by irradiation with ß-rays in step D).

**18.** The process as claimed in claim 1, **characterized in that** the membrane produced in step D is supplied with a catalytic active layer.

**19.** The process as claimed in claim 1, **characterized in that** the formation of the membrane according to steps A) to

D) is carried out on a support or a support film on which the catalyst is present, and the catalyst is located on the membrane according to the invention after removal of the support or the support film.

**20.** The process as claimed in claim 1, **characterized in that** the formation of the membrane according to steps A) to D) is carried out on an electrode as support.

**21.** The process as claimed in claim 20, wherein the membrane formed has a thickness in the range from 2 to 3000 μm, preferably from 3 to 2000 μm, in particular from 5 to 1500 μm.

## Revendications

**1.** Procédé pour la fabrication d'une membrane polymère conductrice de protons à base de polyazoles comprenant les étapes :

A) Mélange d'un ou plusieurs composés tétra-amino aromatiques avec un ou plusieurs acides carboxyliques aromatiques ou leurs esters, qui contiennent au moins deux groupes d'acide par monomère d'acide carboxylique, ou mélange d'un ou plusieurs acides diaminocarboxyliques aromatiques et/ou hétéroaromatiques, dans de l'acide phosphorique avec une concentration de 85% et plus, qui ne présente pas d'acide polyphosphorique de la formule $H_{n+2}P_nO_{3n+1}$ (n≥2) sous formation d'une solution et / ou dispersion ;
B) Réchauffement de la solution et / ou dispersion obtenue selon étape A), à une température pouvant atteindre 350°C, de préférence 280°C sous formation du polymère polyazole ;
C) Pose d'une couche en utilisant le mélage selon étape B) sur un support ;
D) Traitement de la membrane formée à l'étape C).

**2.** Procédé selon revendication 1, **caractérisé en ce que** les composés tétramino aromatiques sont tétraaminobiphényle 3,3'-4,4', tétraaminopyridine 2,3,5,6, tétraaminobenzole 1,2,4,5, sulfone de tétraaminodiphényle 3,3',4,4', éther tétraaminodiphényle3,3'4,4', tétraaminobenzophénone 3,3'4,4', méthane tétraaminodiphényle 3,3'4,4' et méthane tétraaminodiphényldiméthyle 3,3',4,4' .

**3.** Procédé selon revendication 1, **caractérisé en ce qu'**on utilise en tant qu'acides dicarboxyliques, de l'acide isophtalique, acide téréphtalique, acide phtalique, acide hydroxyisophtalique 5, acide hydroxyisophtalique 4, acide hydroxyterephtalique 2, acide aminoisophtalique 5, acide diméthylaminoisophtalique 5-N,N, acide diéthylaminoisophtalique 5-N,N, acide dihydroxytérephtalique 2,5, acide dihydroxyisophtalique 2,5, acide dihydroxyisophtalique 2,3, acide dihydroxyphtalique-2,3, acide dihydroxyphtalique 2,4, acide dihydroxyphtalique 3,4, acide fluorophtalique-3, acide fluoroisophtalique-5, acide flurotérephtalique-2, acide tétrafluorophtalique, acide tétrafluoroisophtalique, acide tétrafluorotérephtalique, acide naphtalène dicarboxylique-1,4, acide naphtalène dicarboxylique-1,5, acide naphtalène dicarboxylique-2,6, acide naphtalène dicarboxylique- 2,7, acide diphénique, acide dihydroxynaphtalène-1,8-dicarboxylique-3,6, acide éther de diphényl-4,4'- dicarboxylique, acide benzophénone dicarboxylique-4,4, acide diphénylsulfone-dicarboxylique 4,4', acide biphényle-dicarboxylique 4,4', acide trifluorométhylphtalique-4, hexafluoropropène bis(carboxy phényle-4), acide stilbènedicarbolixyque-4,4', acide carboxycinnamique-4, ou leurs esters alkyle C1-C20 ou esters aryles C5-C12 ou leurs anhydrides d'acide ou leurs chlorures d'acide.

**4.** Procédé selon revendication 1, **caractérisé en ce qu'**on utilise en tant qu'acide carboxylique des acides tricarboxyliques, acides tétracarboxyliques ou leurs esters alkyle C1-C20 ou esters aryle C5-C12 ou leurs anhydrides d'acide ou leurs chlorures d'acide, de préférence acide tricaboxylique de benzène-1,3,5 (acide trimesique), acide tricarboxylique de benzène 1,2,4 (acide tremellitique), acide iminodiacétique de carboxyphényle-2, acide tricarboxylique de biphényle-3,5,3' ou acide tricaboxylique de biphényle-3,5,4' et / ou acide tricarboxylique de pyridine 2,4,6.

**5.** Procédé selon revendication 1, **caractérisé en ce qu'**on utilise en tant qu'acide carboxylique aromatique des acides tétracarboxyliques, leurs esters alkyle C1-C20 ou esters aryle C5-C12 ou leurs anhydrides d'acide ou leurs chlorures d'acide, de préférence acides tétracarboxyliques 1,2,4,5 de benzène; acides tétracarboxyliques 1,4,5,8 de naphtaline, acide tétracarboxylique de biphényle 3,5,3',5,' ; acide tétracarboxylique de benzophénone, acide tétracarboxylique de biphényle 3,3',4,4', acide tétracarboxylique de biphényle 2,2,',3,3', acide tétracarboxylique de naphtaline 1,2,5,6, acide tétracarboxylique de naphtaline 1,4,5,8.

**6.** Procédé selon revendication 4, **caractérisé en ce que** la teneur en acide tricarboxyliques ou acides tétracarboxyliques (par rapport à l'acide dicarboxylique utilisé) est comprise entre 0,5 et 20 % de mol.

**7.** Procédé selon revendication 1, **caractérisé en ce qu'**on utilise en tant qu'acides carboxyliques hétéroaromatiques des acides hétéroaromatiques dibarboxyliques et tricarboxyliques et tétracarboxyliques lesquels contiennent au moins un atome d'azote, d'oxygène, de soufre ou de phosphore dans l'aromat, de préférence acide dicarboxylique-2,5 de pyridine, d'acide dicarboxylique 3,5 de pyridine, d'acide dicarboxylique 2,6 de pyridine, d'acide dicarboxylique 2,4 de pyridine, d'acide dicarboxylique de pyridine 2,5 de phényle-4, d'acide dicarboxylique de pyrazole-3,5, d'acide dicarboxylique de pyrimidine-2,6, d'acide dicarboxylique de pyrazine-2,5, d'acide tricarboxylique de pyridine-2,4,6 ou acide dicarboxylique-5,6 de benzimidazole et leurs esters alkyle C1-C20 ou esters aryle C5-C12, ou leurs anhydrides d'acide ou leurs chlorures d'acide.

**8.** Procédé selon revendication 1, **caractérisé en ce que** dans l'étape B) un polymère à base de polyazole contient des unités récurrentes d'azole de la formule générale (I) et/ou (II) et/ou (III) et/ou (IV) et/ou (V) et/ou (VI) et/ou (VII) et/ou (VIII) et/ou (IX) et/ou (X) et/ou (XI) et/ou (XII) et/ou (XIII) et/ou (XIV) et/ou (XV) et/ou (XVI) et/ou (XVII) et/ou (XVIII) et/ou (XIX) et/ou (XX) et/ou (XXI) et/ou (XXII).

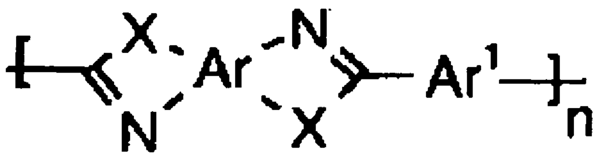

(I)

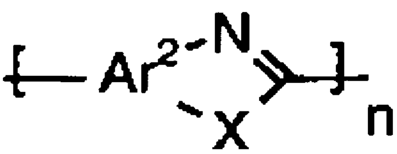

(II)

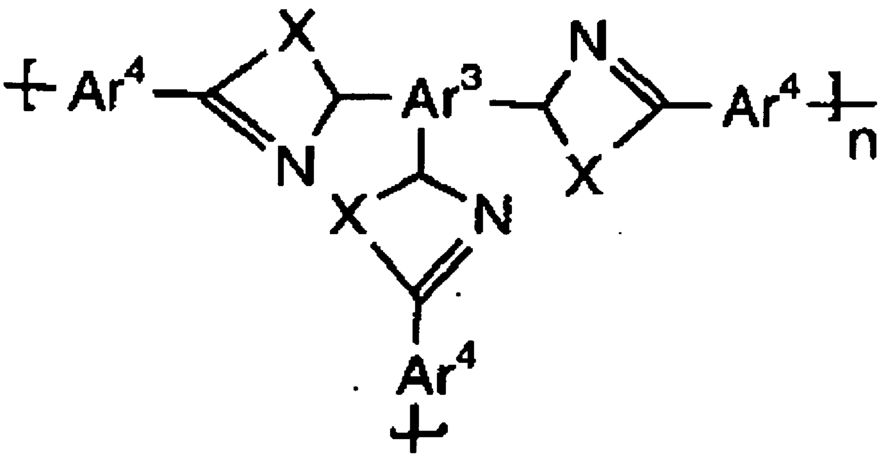

(III)

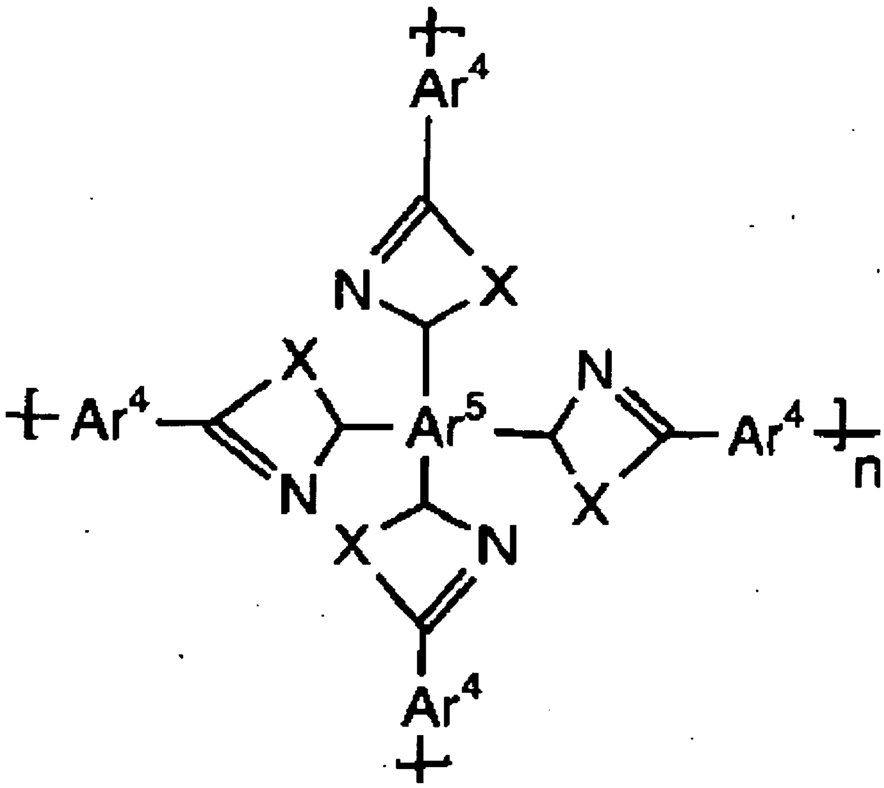

(IV)

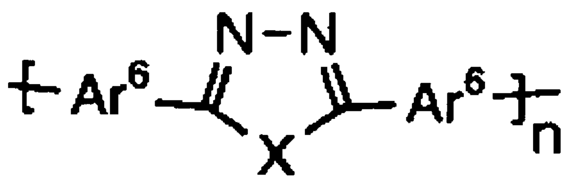

(V)

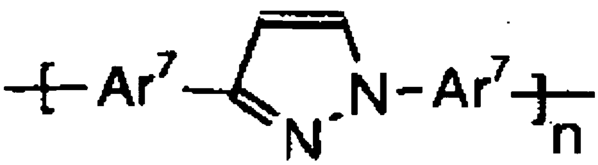

(VI)

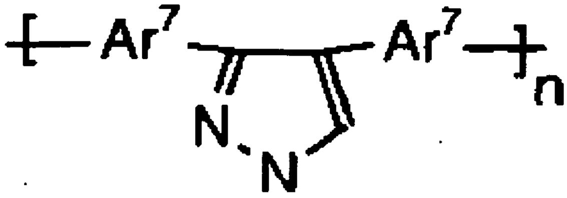

(VII)

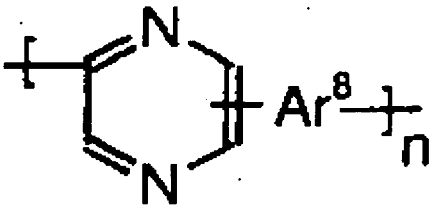

(VIII)

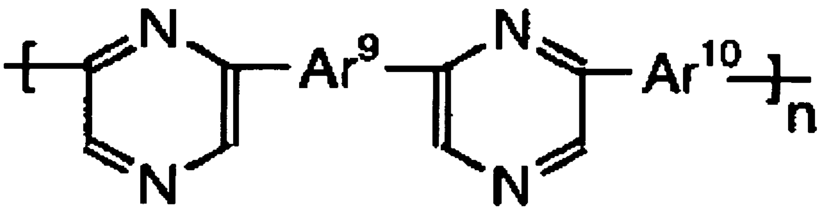

(IX)

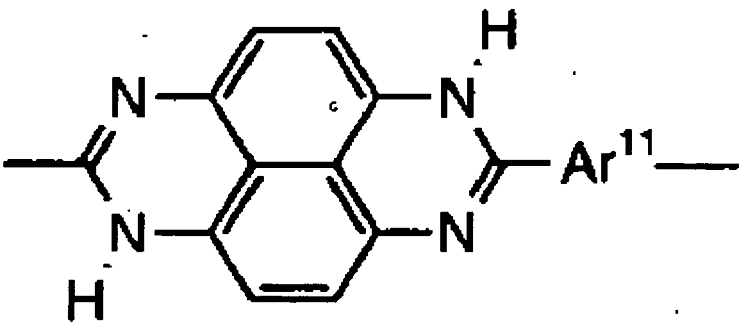

(X)

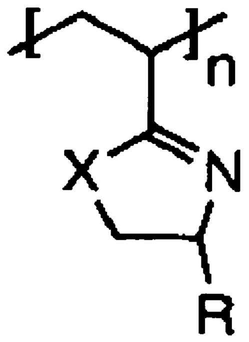

(XI)

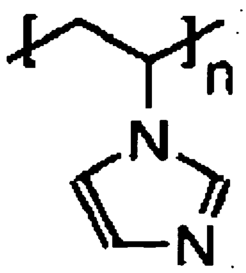

(XII)

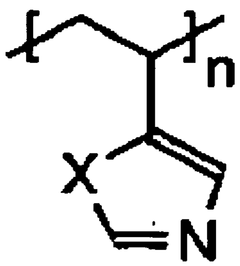

(XIII)

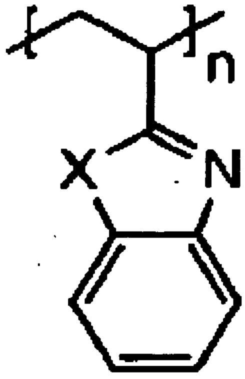

(XIV)

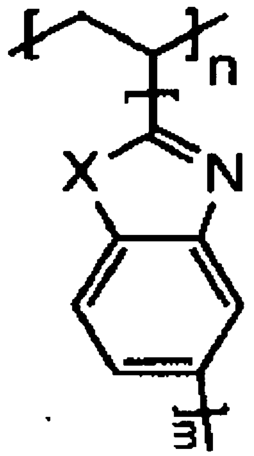

(XV)

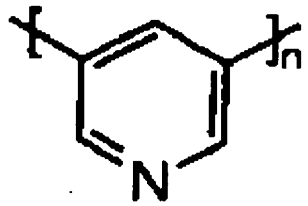

(XVI)

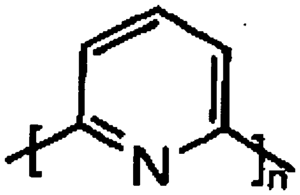

(XVII)

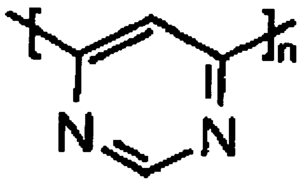

(XVIII)

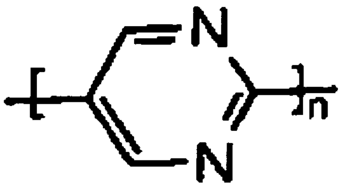

(XIX)

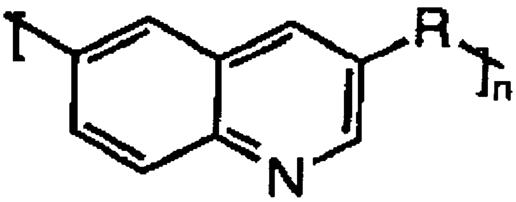

(XX)

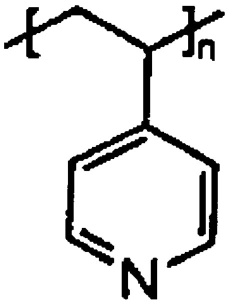

(XXI)

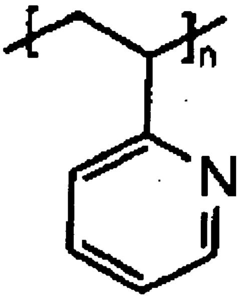

(XXI]

dans lesquelles

Ar sont identiques ou différents et représentent un groupe aromatique ou hétéroaromatique à quatre liaisons qui peut être à un ou à plusieurs noyaux,
$Ar^1$ sont identiques ou différents et désignent un groupe aromatique ou hétéroaromatique à deux liaisons, qui peut être à un ou plusieurs noyaux,
$Ar^2$ sont identiques ou différents et désignent un groupe aromatique ou hétéroaromatique à deux ou trois

liaisons, qui peut être à un ou plusieurs noyaux,

$Ar^3$ sont identiques ou différents et désignent un groupe aromatique ou hétéroaromatique à trois liaisons, qui peut être à un ou plusieurs noyaux,

$Ar^4$ sont identiques ou différents et désignent un groupe aromatique ou hétéroaromatique à trois liaisons, qui peut être à un ou plusieurs noyaux,

$Ar^5$ sont identiques ou différents et désignent un groupe aromatique ou hétéroaromatique à quatre liaisons, qui peut être à un ou plusieurs noyaux,

$Ar^6$ sont identiques ou différents et désignent un groupe aromatique ou hétéroaromatique à deux liaisons, qui peut être à un ou plusieurs noyaux,

$Ar^7$ sont identiques ou différents et désignent un groupe aromatique ou hétéroaromatique à deux liaisons, qui peut être à un ou plusieurs noyaux,

$Ar^8$ sont identiques ou différents et désignent un groupe aromatique ou hétéroaromatique à trois liaisons, qui peut être à un ou plusieurs noyaux,

$Ar^9$ sont identiques ou différents et désignent un groupe aromatique ou hétéroaromatique à deux ou trois ou quatre liaisons, qui peut être à un ou plusieurs noyaux,

$Ar^{10}$ sont identiques ou différents et désignent un groupe aromatique ou hétéroaromatique à deux ou trois liaisons, qui peut être à un ou plusieurs noyaux,

$Ar^{11}$ sont identiques ou différents et désignent un groupe aromatique ou hétéroaromatique à deux liaisons, qui peut être à un ou plusieurs noyaux,

X est identique ou différent et désigne l'oxygène, le soufre ou un groupe aminé, qui porte un atome d'hydrogène, un groupe présentant un atome de carbone 1-20, de préférence un groupe alkyle ou alkoxy ramifié ou non ramifié, ou un groupe aryle en tant qu'autre radical

R est identique ou différent, désigne l'hydrogène, un groupe alkyle et un groupe aromatique et R désigne dans la formule (XX) un groupe alkyle et un groupe aromatique

n, m est un nombre entier supérieur ou égal à 10, de préférence supérieur ou égal à 100.

9. Procédé selon revendication 1, **caractérisé en ce que** dans l'étape B) un polymère sélectionné dans le groupe polybenzimidazole, polypiridine, polypyrimidine, polymidazole, polybenzthiazole, polybenzoxazole, polyoxadiazole, polyquinoxaline, polythiadiazole et polytétrazapyrène, est formé.

10. Procédé selon revendication 1, **caractérisé en ce que** dans l'étape B) un polymère comprenant des unités récurrentes de benzimidazole des formules

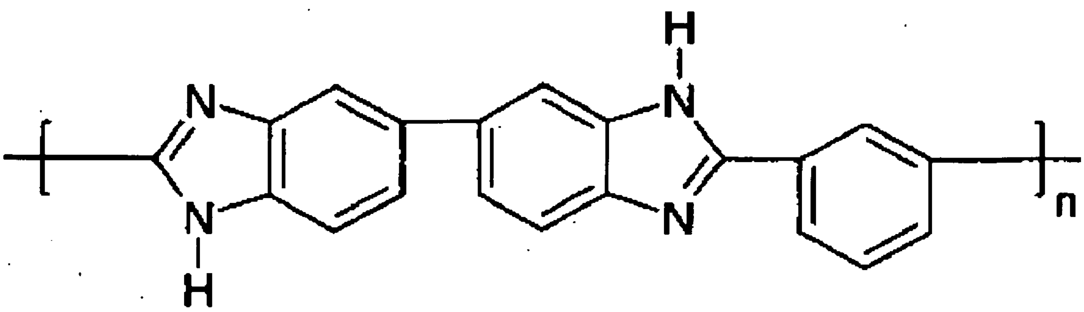

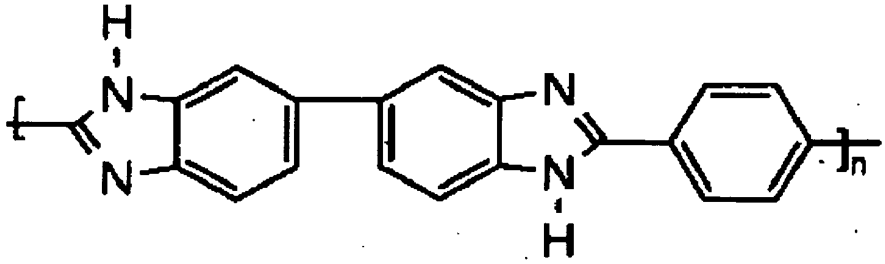

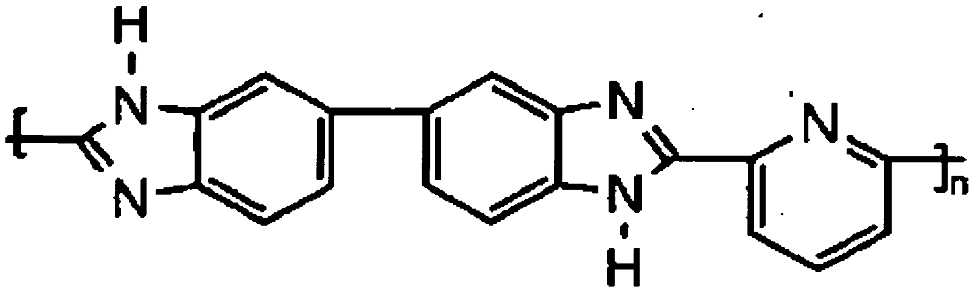

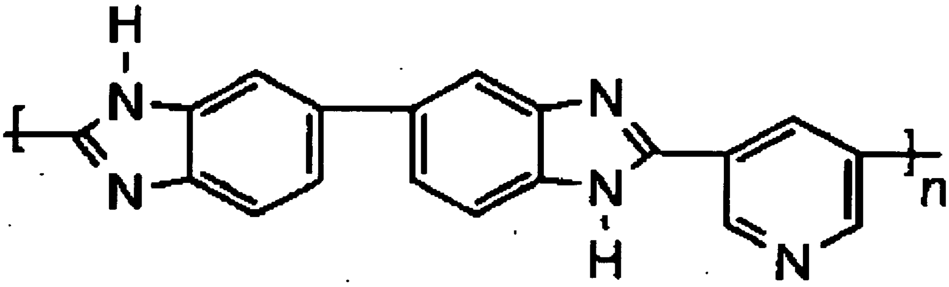

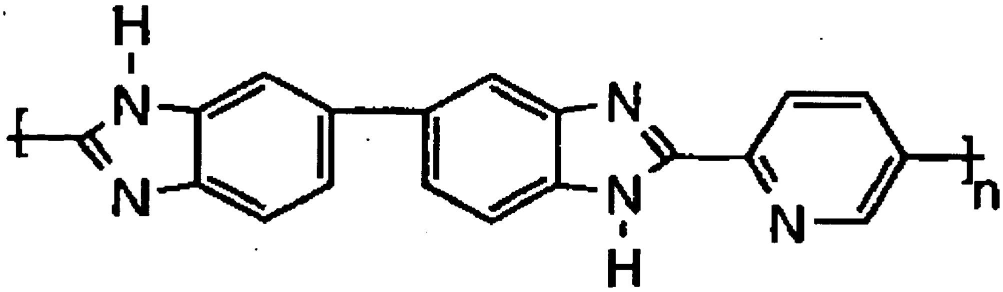

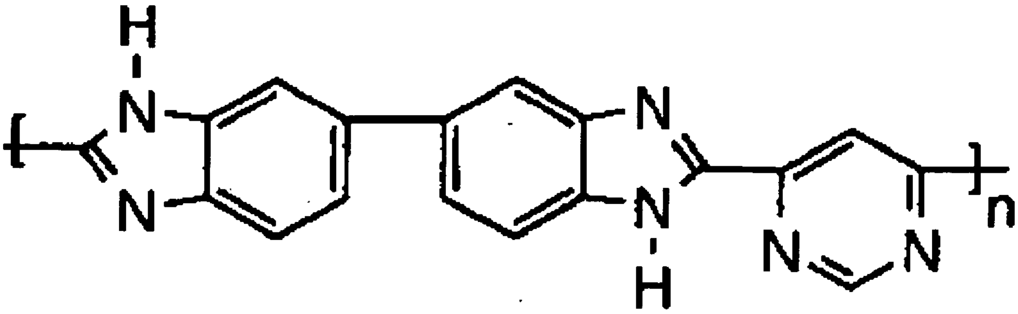

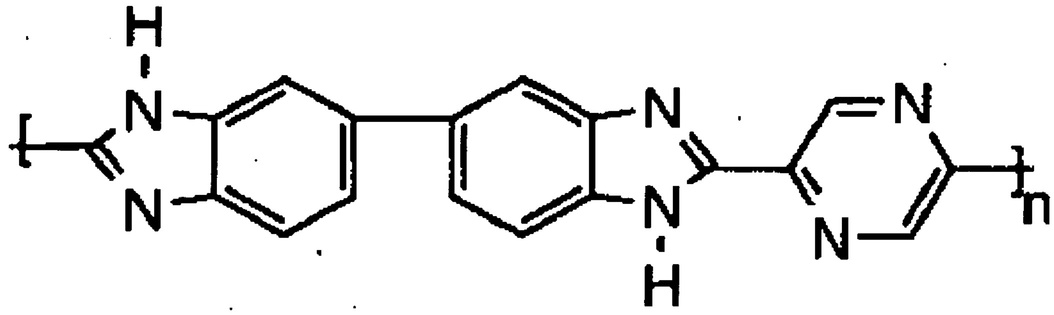

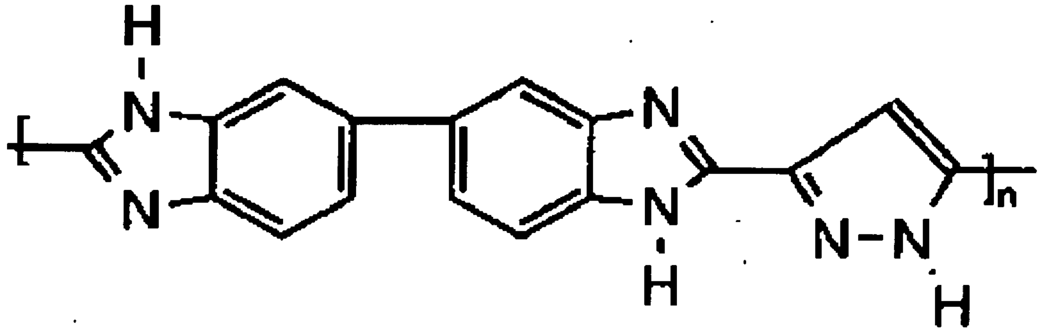

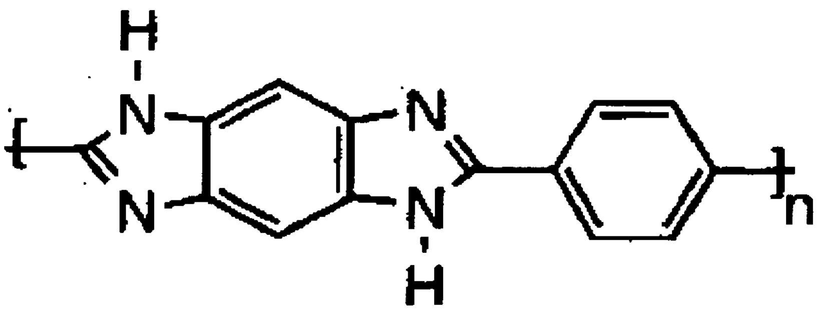

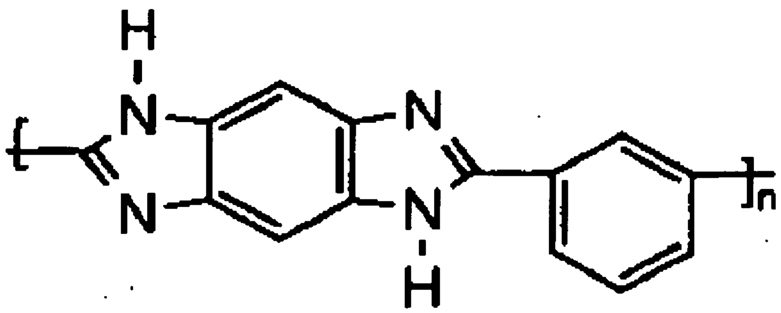

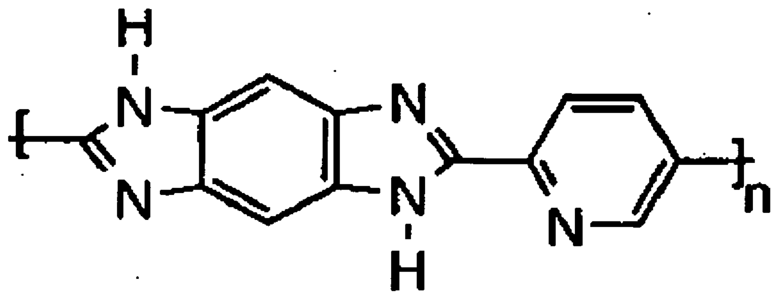

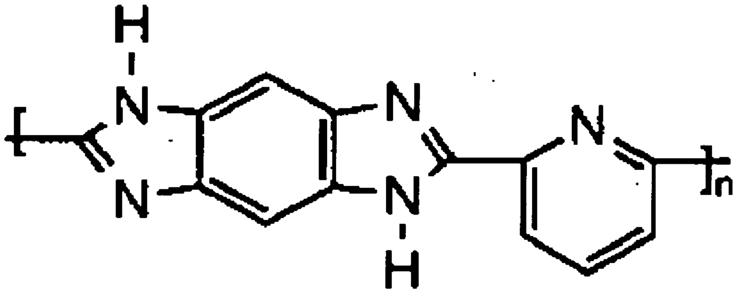

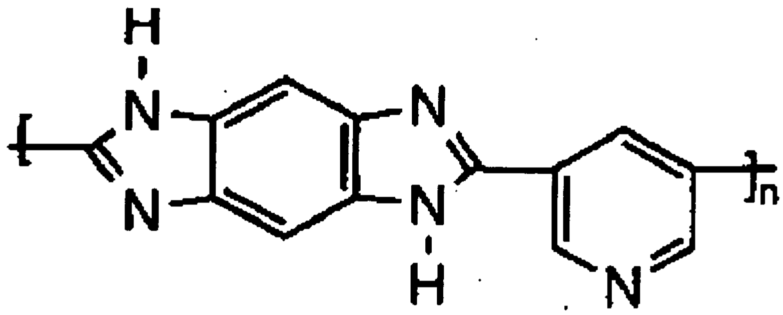

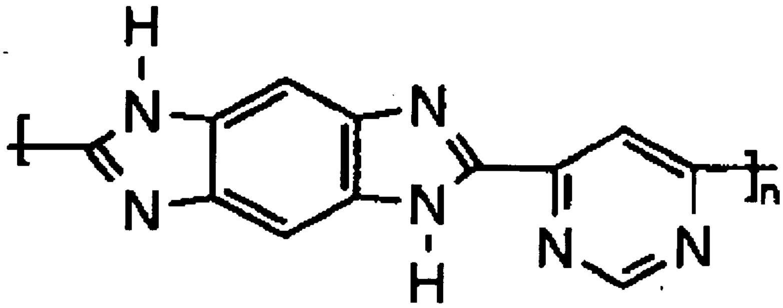

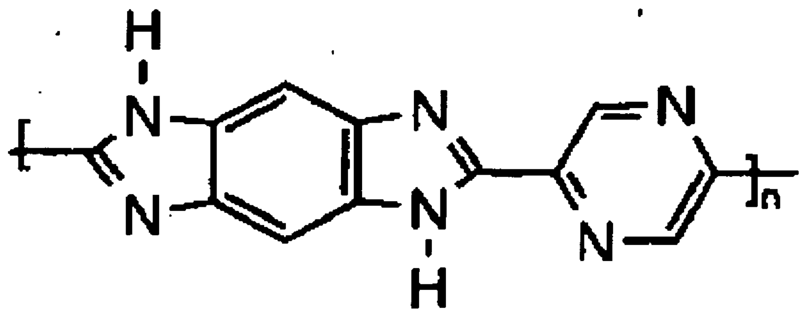

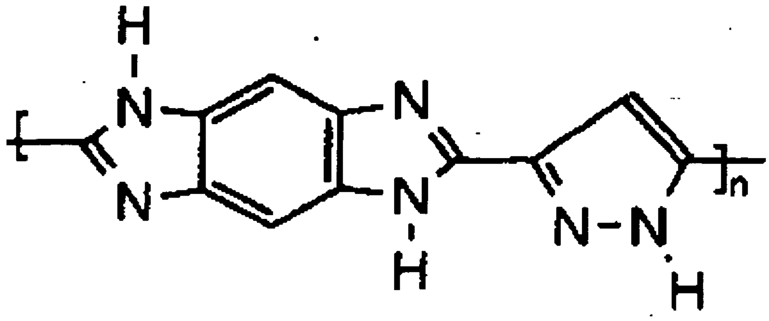

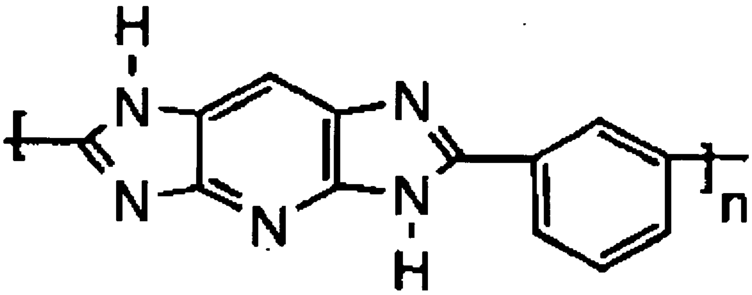

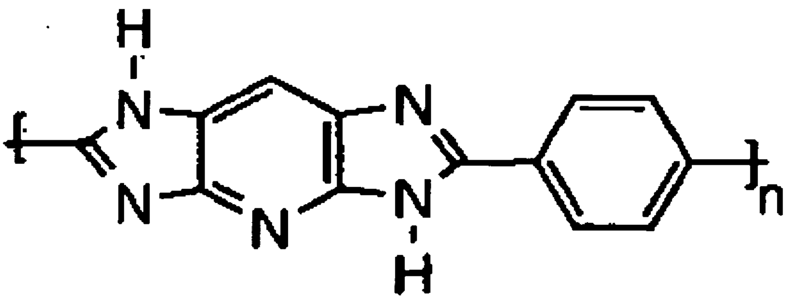

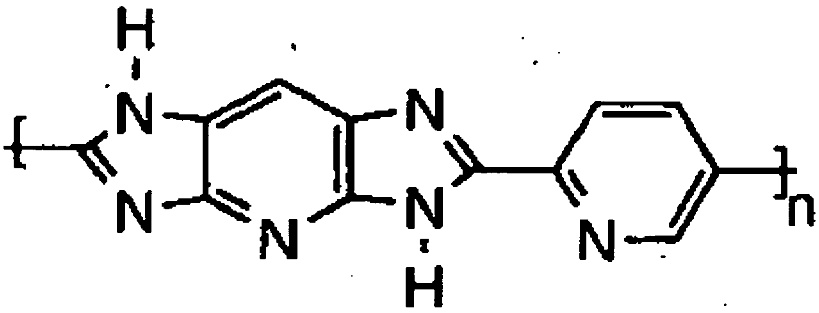

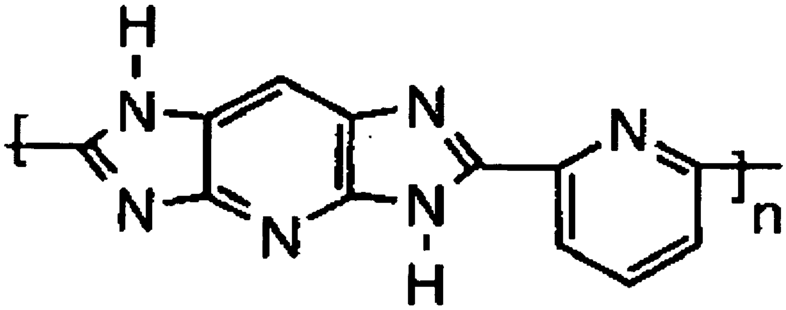

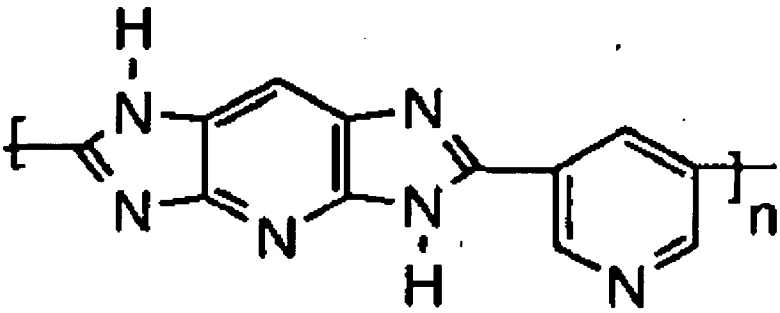

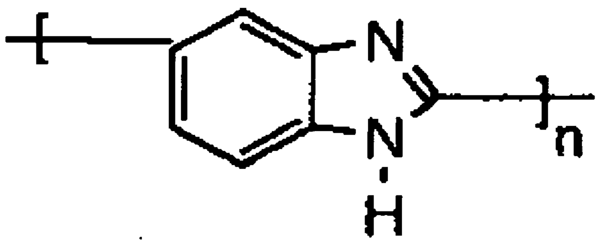

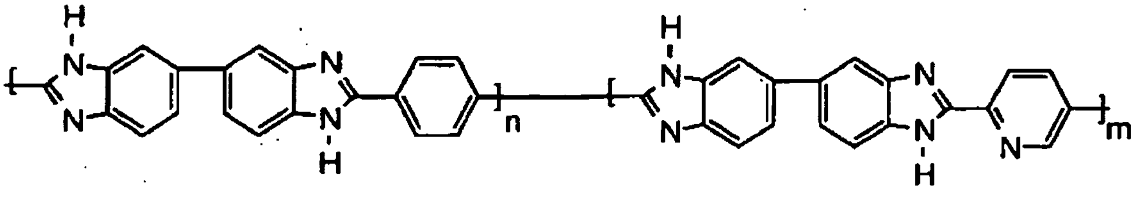

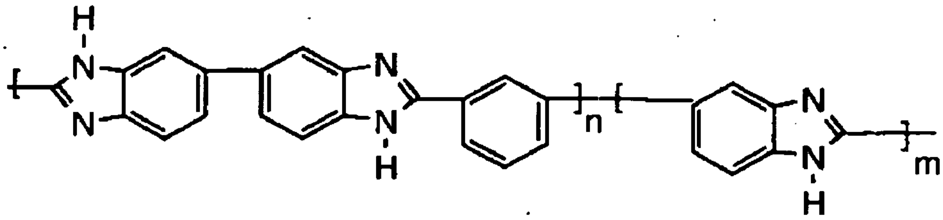

sachant que n et m est un nombre entier supérieur ou égal à 10, de préférence supérieur à 100, est formé.

**11.** Procédé selon revendication 1, **caractérisé en ce qu'**après l'étape B) et avant l'étape AC, la viscosité est réglée par ajout d'acide phosphorique.

**12.** Procédé selon revendication 1, **caractérisé en ce que** dans l'étape C), une couche d'une épaisseur comprise entre 20 et 4000 µm, de préférence entre 30 et 3500 µm, de manière particulièrement préférée entre 50 et 3000 µm, est fabriquée.

**13.** Procédé selon revendication 1, **caractérisé en ce que** la membrane fabriquée selon l'étape C, est traitée dans l'étape D) jusqu'à ce que la membrane soit autoporteuse et puisse être détachée du support sans être endommagée.

**14.** Procédé selon revendication 1, **caractérisé en ce que** la membrane fabriquée selon l'étape C) est traitée sous l'influence de la chaleur en présence d'oxygène de l'air.

**15.** Procédé selon revendication 1, **caractérisé en ce que** la membrane fabriquée selon l'étape C) contient encore des aicdes tricarboxyliques ou tétracarboxyliques, qui sont réticulés dans l'étape D).

**16.** Procédé selon revendication 1, **caractérisé en ce que** la membrane fabriquée à l'étape C) est réticulée dans l'étape D) par un traitement avec de l'acide de soufre.

**17.** Procédé selon revendication 1, **caractérisé en ce que** la membrane fabriquée selon l'étape C) est réticulée dans l'étape D) sous l'influence de lumière IR (infrarouge) ou NIR (proche infrarouge) et par rayonnement avec des rayons β.

**18.** Procédé selon revendication 1, **caractérisé en ce que** la membrane fabriquée selon l'étape D) est pourvue d'une couche catalytiquement active.

**19.** Procédé selon revendication 1, **caractérisé en ce que** la formation de la membrane selon les étapes A) à D) s'effectue sur un support ou feuille support, qui présente déjà le catalyseur et après retrait du support ou de la feuille support, le catalyseur se trouve sur la membrane conforme à l'invention.

**20.** Procédé selon revendication 1, **caractérisé en ce que** la formation de la membrane selon les étapes A) à D) s'effectue sur une électrode en tant que support.

**21.** Procédé selon revendication 20, **caractérisé en ce que** la couche de membrane formée a une épaisseur comprise entre 2 et 3000 µm, de préférence entre 3 et 2000 µm, de manière particulièrement préférée entre 5 et 1500 µm.

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente


- US 5633337 A
- DE 10109829
- JP 2001118591 A
- US 4191618 A
- US 4212714 A
- US 4333805 A


### In der Beschreibung aufgeführte Nicht-Patentliteratur


- **Gang, Xiao ; Hjuler, H. A. ; Olsen, C. ; Berg, R. W. ; Bjerrum, N.** Electrolyte additives for phosphoric acid fuel cells. *J.. Chem. Dep. A, Tech. Univ. Denmark, Lyngby, Den. J. Electrochem. Soc.,* 1993, vol. 140 (4), 896-902
- **Razaq, M. ; Razaq, A. ; Yeager, E. ; DesMarteau, Darryl D. ; Singh, S.** Perfluorosulfonimide as an additive in phosphoric acid fuel cell. *Case Cent. Electrochem. Sci.*
- *J. Electrochem. Soc.,* 1989, vol. 136 (2), 385-90
- **F. Gugumus.** Plastics Additives. Hanser Verlag, 1990
- **N.S. Allen ; M. Edge.** Fundamentals of Polymer Degradation and Stability. Elsevier, 1992
- **H. Zweifel.** Stabilization of Polymeric Materials. Springer, 1998